# EUROPEAN PATENT APPLICATION

(11) **EP 4 790 689 A1**
(43) Date of publication of application: **12.08.2026**
(21) Application number: 24874875.8
(22) Date of filing: 10.09.2024
(51) Int. Cl.: G09F 19/12, G09F 9/30, G06F 1/16, H10K 77/10, H10K 59/40, H10K 59/38, H10K 59/80, G09F 19/18, B60K 35/00

(54) **VEHICLE DISPLAY DEVICE AND METHOD FOR OPERATING SAME**

(30) Priority: 06.10.2023 KR 20230133549
(71) Applicant: LG Electronics Inc., Yeongdeungpo-gu Seoul 07336 (KR)
(72) Inventor: KANG, Seungmo, Seoul 06772 (KR); KIM, Taeil, Seoul 06772 (KR); KIM, Hansoo, Seoul 06772 (KR); SHIM, Inkoo, Seoul 06772 (KR); DIBOINE, Romain, Seoul 06772 (KR)
(74) Representative: Vossius & Partner Patentanwälte Rechtsanwälte mbB
(86) International application number: PCT/KR2024/013706
(87) International publication number: WO 2025/075317

(57) **Abstract**

A vehicle display device is disclosed. The vehicle display device according to an embodiment of the present invention comprises: a housing having a recessed inner space formed therein; a display disposed on one side of the inner space of the housing; a communication module configured to receive vehicle information from a vehicle; a first reflection module coupled to one side of the display in the inner space and disposed such that graphics emitted from the first area of the display are refracted so as to form a first screen area; a second reflection module coupled to one side of the first reflection module in the inner space and disposed such that graphics emitted from the second area of the display are refracted so as to form a second screen area; and a processor for controlling operations thereof. The processor controls the first and second reflection modules so as to display information having different depth values on the first and second screen areas on the basis of the received vehicle information when the display is driven. Accordingly, different screen areas are used independently or in conjunction with each other, thereby providing more diversified user environments and user experiences.

## Description

### Technical Field

The present disclosure relates to a vehicular display device. More particularly, the present disclosure pertains to a vehicular display device configured to form a plurality of screens using graphic light emerging from a single display module.

### Background Art

A vehicle is an apparatus that transports a user in a direction desired by the user. A typical example of a vehicle is an automobile.

A trend has emerged in which vehicles are equipped with various sensors, electronic devices, and equivalents thereof to improve user convenience. Particularly, to enhance user convenience, extensive research has been conducted on Advanced Driver Assistance Systems (ADAS). Furthermore, the development of autonomous vehicles has been actively conducted.

The term 'autonomous driving' refers to a system in which the vehicle is capable of determining driving behavior and operating without input from the occupant. This autonomous driving may be categorized into progressive stages ranging from non-automation to full automation, depending on the degree to which the system is involved in driving and the extent to which the driver controls the vehicle.

Autonomous driving of vehicles has transformed the perception of vehicles from being merely a means of transportation to being a space where one can dwell. Moreover, a trend has emerged in which displays of ever-increasing size are mounted in vehicles to allow users to enjoy various infotainment content. In addition, research and development has been conducted to provide a more diverse usage environment when using the display.

### Disclosure of Invention

### Technical Problem

Objects of the present disclosure are to address the above-mentioned problems and other related problems.

According to some embodiments of the present disclosure, one object of the present disclosure is to provide a vehicular display device capable of providing a plurality of usage environments using a single display, and a method of operating the vehicular display device.

According to some embodiments of the present disclosure, another object of the present disclosure is to provide a vehicular display device capable of using, selectively or simultaneously, different types of usage environments formed through a single display, and a method of operating the vehicular display device.

According to some embodiments of the present disclosure, a further object of the present disclosure is to provide a vehicular display device capable of varying a position at which a 2D graphic floats according to a user's field of view, a content type, or content movement, and a method of operating the vehicular display device.

According to some embodiments of the present disclosure, another object of the present disclosure is to provide a vehicular display device capable of allowing a user to intuitively recognize whether pieces of information to be displayed in different types of screens are associated with each other, and a method of operating the vehicular display device.

According to some embodiments of the present disclosure, still another object of the present disclosure is to provide a vehicular display device capable of providing various user environments and user experiences using different screen regions independently or associating the different screen regions with each other, and a method of operating the vehicular display device.

### Solution to Problem

To accomplish the above-mentioned objects, a vehicular display device according to an embodiment of the present disclosure is capable of generating a plurality of screens having different depth values by refracting or reflecting graphic light emerging from one display through different reflective modules.

According to an aspect of the present disclosure, there is provided a vehicular display device including: a housing recessed to form an inner space inside; a display arranged on one side of the inner space in the housing; a communication module that receives vehicle information from a vehicle; a first reflective module coupled to one side of the display in the inner space and arranged in such a manner that graphic light emitted from a first region of the display forms a first screen region after refraction; a second reflective module coupled to one side of the first reflective module in the inner space and arranged in such a manner that graphic light emitted from a second region of the display forms a second screen region after reflection; and a processor electrically coupled to the first and second reflective modules and controlling respective operations of the first and second reflective modules. When operating the display, the processor controls the first and second reflective modules on the basis of the received vehicle information in such a manner that pieces of information having different depth values are displayed in the first and second screen regions, respectively.

In an embodiment, in the vehicular display device, the processor may determine whether pieces of information to be displayed in the first and second screen regions, respectively, are associated with each other, and, based on the determination, may control the first and second screen regions in such a manner that the depth values are changed.

In an embodiment, the first screen region may be a prism region, and the second screen region may be a floating region in which a virtual (AR) image is displayed below the prism region. Based on the association of the pieces of information to be displayed in the prism region and the floating region, respectively, the processor may adjust the depth values through the first and second reflective modules in such a manner that images to be displayed in the prism region and the floating region, respectively, are positioned on the same plane.

In an embodiment, in the vehicular display device, based on the association of the pieces of information to be displayed in the prism region and the floating region, respectively, an image to be displayed in the floating region may be displayed in the prism region while moving downward from above in a seamlessly continuous manner.

In an embodiment, in the vehicular display device, the processor may control the display and the first and second reflective modules based on the association of the pieces of information to be displayed in the prism region and the floating region, respectively, in such a manner that content related to the vehicle information is displayed on the prism region and that a result of executing the content is displayed in the floating region.

In an embodiment, in the vehicular display device, driving guidance information may be displayed as content related to the vehicle information in the prism region, and, based on a change in an importance level of the driving guidance information, the extended driving guidance information, as a result of executing the content, may be displayed in the floating region.

In an embodiment, in the vehicular display device, the prism region may be formed to receive a touch input, and, based on a touch input to content displayed in the prism region, the processor may control the display and the first and second reflective modules in such a manner that an execution result matched to the touch input is displayed in the floating region.

In an embodiment, in the vehicular display device, in a case where the pieces of information displayed in the prism region and the floating region, respectively, are disassociated with each other, the image in the prism region may remain displayed, and the image in the floating region may disappear during movement to a boundary between the prism region and the floating region.

In an embodiment, in the vehicular display device, based on disassociation of the pieces of information to be displayed in the prism region and the floating region, respectively, the image to be displayed in the floating region may be vertically spread, originating from the center of the floating region.

In an embodiment, in the vehicular display device, based on disassociation of the pieces of information to be displayed in the prism region and the floating region, respectively, the image to be displayed in the floating region may be displayed while moving upward from below the floating region.

In an embodiment, in the vehicular display device, in a state where the vehicle is stopped or is driven in an autonomous driving mode on the basis of the received vehicle information, when operating the display, the processor may adjust the depth values in such a manner that images to be displayed in the first and second screen regions, respectively, are positioned on the same plane in a seamlessly continuous manner.

In an embodiment, in the vehicular display device, based on an importance level of the vehicle information, the processor may control the first and second reflective modules in such a manner that the pieces of information having different depth values are selectively displayed in the first and second screen regions, respectively.

In an embodiment, in the vehicular display device, while the pieces of information having different depth values are displayed in the first and second screen regions, respectively, the processor may control an operation of the second reflective module based on a driving situation included in the vehicle information in such a manner as to limit display in the second screen region.

### Advantageous Effects of Invention

A vehicular display device according to an embodiment of the present disclosure can execute a plurality of different display modes selectively or simultaneously using a single display module. For example, a real image and an aerial image may be displayed selectively or simultaneously using only a single display.

In addition, the vehicular display device according to an embodiment of the present disclosure can vary a position of a 3D virtual image floating according to a content type or content movement, based on a user's field of view, thereby displaying a graphic image in such a manner that the 3D virtual image falls within the user's field of view and that a sense of immersion and a floating effect are maximized.

In addition, the vehicular display device according to the embodiment of the present disclosure can adjust and display depth values depending on whether the real image and the aerial image are associated with each other, thereby allowing the user to intuitively recognize whether pieces of information displayed on different types of screens are associated with each other.

Specifically, the vehicular display device according to the embodiment of the present disclosure can display pieces of information associated with each other, which are derived from one source image in a prism region and a floating region as if the pieces of information appear as one seamlessly connected screen. In addition, a result of executing content displayed in the prism region can also be displayed in the floating region. In addition, depending on whether to increase an attention or alarm level, information displayed only in the prism region can be displayed in a manner that expands into the floating region, or an image can be no longer displayed in the floating region. Accordingly, a more diverse user environment and user experience can be provided by using different screen regions independently or in an associated manner.

### Brief Description of Drawings

FIGS. 1 and 2 are block diagrams that are referenced to describe the configuration of a vehicle according to the present disclosure.
FIG. 3 is a view illustrating an example in which a vehicular display device according to the present disclosure operates after installation.
FIG. 4 is an exemplary block diagram that is referenced to describe the detailed configuration of the vehicular display device according to the present disclosure.
FIG. 5 is a perspective view illustrating the vehicular display device according to the present disclosure.
FIG. 6 is a cross-sectional view illustrating a state where a prism display region and a floating display region are formed when the vehicular display device according to the present disclosure operates, when viewed from the side.
FIG. 7 is an exemplary view that is referenced to describe a plurality of display regions in accordance with a display mode of the vehicular display device according to the present disclosure.
FIG. 8 is a view illustrating the vehicular display device arranged in a cluster or CID region of the vehicle according to the present disclosure, when viewed from the side.
FIG. 9 is an exemplary flowchart that is referenced to describe a method of operating the vehicular display device according to the present disclosure.
FIGS. 10, 11, and 12 are views illustrating exemplary structures of the vehicular display device for executing a plurality of display modes using a single display, according to the present disclosure.
FIG. 13 is a set of conceptual views that are referenced to describe a method of changing a position of an AR image in a floating region in the vehicular display device, according to the present disclosure.
FIGS. 14 and 15 are views that are referenced to describe a state where information in a prism region is displayed in a manner that expands into the floating region or where information in the floating region is displayed in a manner that is reduced into the prism region, according to an embodiment of the present disclosure.
FIG. 16 is a view illustrating an example in which vehicle navigation information is displayed continuously across the prism region and the floating region, according to an embodiment of the present disclosure.
FIGS. 17 and FIG. 18 are views illustrating an example in which, according to a warning level corresponding to a vehicle speed, warning information is displayed in a manner that expands into the floating region, in an embodiment of the present disclosure.
FIG. 19 is a view illustrating an example in which, based on a distance between vehicles, the warning information is displayed in a manner that expands into the floating region, in an embodiment of the present disclosure.
FIGS. 20 and 21 are exemplary views that are referenced to describe the prism region and the floating region that are allocated to an occupant in a driver's seat and an occupant in a front passenger seat, respectively, in an embodiment of the present disclosure.
FIG. 22 is a view illustrating an example in which a result of executing an entertainment function is displayed on the basis of a vehicle driving state in a manner that expands into the floating region.

### Mode for the Invention

Embodiments disclosed in the present specification will be described in detail below with reference to the accompanying drawings. The same reference numerals are used for the same or similar constituent elements, regardless of figure numbers, and redundant descriptions thereof are not repeated. The terms 'module' and 'unit' are hereinafter used interchangeably to name constituent elements solely for the convenience of description in the present specification. These terms are not intended to have different meanings or to indicate different functions. In addition, in describing the embodiments disclosed in the present specification, detailed descriptions of well-known related technologies may be omitted when such descriptions are deemed to obscure the nature and gist of the present disclosure. In addition, the accompanying drawings are merely provided to facilitate understanding of the embodiments disclosed in the present specification and shall not be construed as limiting the technical idea disclosed in the present specification. Furthermore, any modifications, equivalents, or substitutions of constituent elements, to the extent falling within the technical scope of the present disclosure, are intended to be encompassed within the scope of the present disclosure.

The ordinal numbers first, second, and so forth may be used to describe various elements, but they do not limit these elements. These terms are used merely to distinguish among constituent elements having similar functions.

It should be understood that a constituent element, when referred to as 'being connected to' or 'having access to' a different constituent element, may be directly connected to or have direct access to the different constituent element, or may be indirectly connected to or have access to the different constituent element through one or more intermediate constituent elements. Likewise, it should be understood that, when a constituent element is described as being 'connected to' or 'having access to' another constituent element, such connection or access may be direct without the need for one or more intermediary constituent elements.

A noun in singular form, unless clearly indicated otherwise by the context, shall be understood to include the plural form.

The terms 'include,' 'have,' and equivalent expressions, as used in the present application, shall be understood to indicate the presence of a feature, number, step, operation, constituent element, component, or combination thereof, without precluding the possibility of the presence or addition of one or more other features, numbers, steps, operations, constituent elements, components, or combinations thereof.

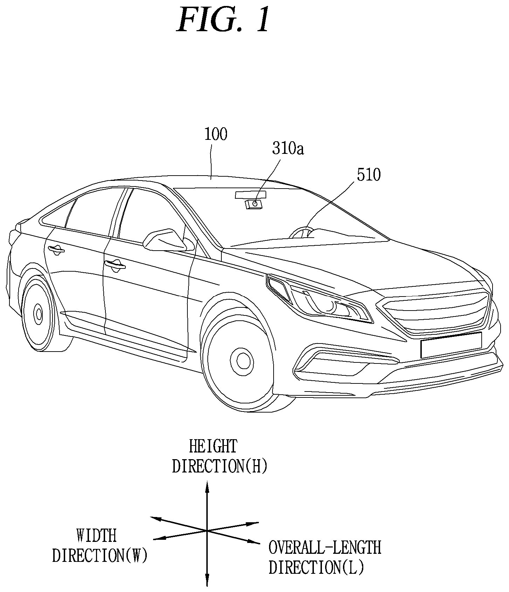

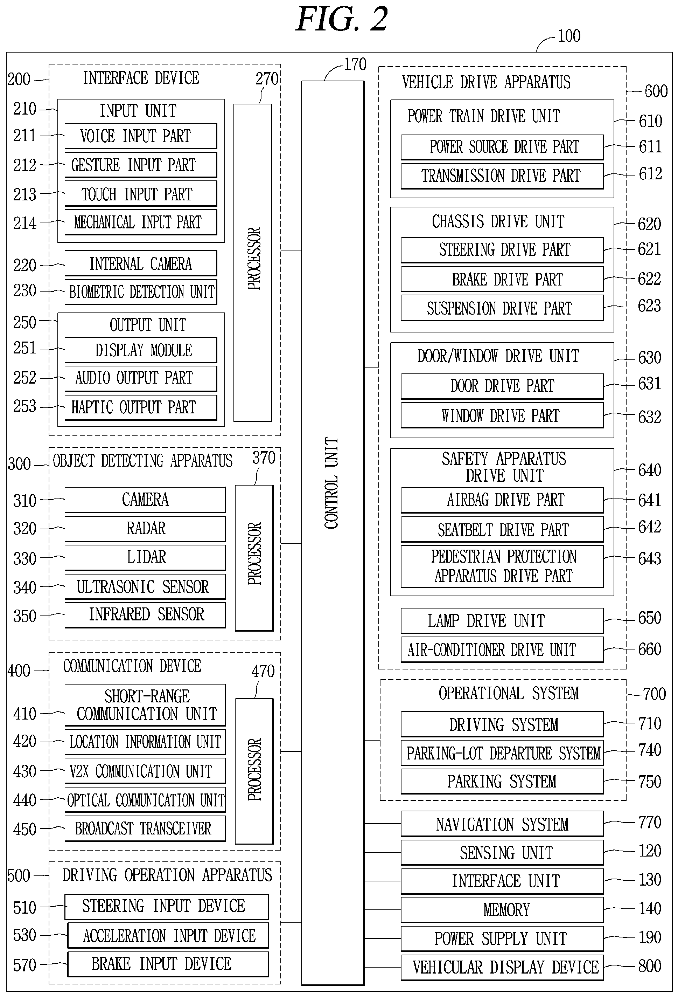

FIGS. 1 and 2 are exemplary block diagrams that are referenced to describe a vehicle according to the present disclosure and the configuration of the vehicle.

With reference to FIG. 1, a vehicle 100 may include wheels that are rotated by a power source and a steering input device 510 for adjusting the traveling direction of the vehicle 100.

The vehicle 100 may be an autonomous driving vehicle. The vehicle 100 may switch to an autonomous driving mode or a manual mode in response to a user input. For example, the vehicle 100 may switch from the manual mode to the autonomous driving mode or from the autonomous driving mode to the manual mode in response to the user input received through a user interface device 200 (hereinafter referred to as a 'user terminal').

The vehicle 100 may switch to the autonomous driving mode or the manual mode on the basis of driving situation information. The driving situation information may be generated on the basis of object information provided by an object detection device 300. For example, the vehicle 100 may switch from the manual mode to the autonomous driving mode or from the autonomous driving mode to the manual mode on the basis of the driving situation information generated by the object detection device 300. For example, the vehicle 100 may switch from the manual mode to the autonomous driving mode or from the autonomous driving mode to the manual mode on the basis of the driving situation information received through a communication device 400.

The vehicle 100 may switch from the manual mode to the autonomous driving mode or from the autonomous driving mode to the manual mode on the basis of information, data, or signals, each of which is provided by an external device.

In a case where the vehicle 100, which is an autonomous driving vehicle, may be driven in the autonomous driving mode, the vehicle 100 may be driven through the use of an operational system 700. For example, the autonomous driving vehicle 100 may be driven on the basis of information, data, or signals, each of which is generated by a driving system 710, a parking-lot departure system 740, or a parking system 750.

In a case where the vehicle 100, which is an autonomous driving vehicle, is driven in the manual mode, the vehicle 100 may receive a user input for driving through a driving operation apparatus 500. The vehicle 100 may be driven in response to the user input received through the driving operation apparatus 500.

The vehicle 100 may include the user interface device 200, the object detection devices 300, the communication device 400, the driving operation apparatus 500, a vehicle driving apparatus 600, the operational system 700, a navigation system 770, a sensing unit 120, a vehicular interface unit 130, a memory 140, a control unit 170, and a power supply unit 190.

According to an embodiment, the vehicle 100 may further include one or more constituent elements in addition to the constituent elements described in the present specification or may omit one or more of the described constituent elements.

The user interface device 200 is a device for communication between the vehicle 100 and the user. The user interface device 200 may receive the user input and may provide information, generated by the vehicle 100, to the user. The vehicle 100 may provide a user interface (UI) or user experience (UX) through the user interface device (hereinafter referred to as the 'user terminal') 200.

The user interface device 200 may include an input unit 210, an internal camera 220, a biometric detection unit 230, an output unit 250, and a processor 270. According to an embodiment, the user interface device 200 may further include one or more constituent elements in addition to the constituent elements described in the present specification or may omit one or more of the described constituent elements.

The input unit 210 serves to receive information as input from the user. The processor 270 may analyze data collected through the input unit 210 and may convert the data into a control command of the user.

The input unit 210 may be arranged within the vehicle 100. For example, the input unit 210 may be arranged in a region of the steering wheel, a region of the instrument panel, a region of the seat, a region of each pillar, a region of the door, a region of the center console, a region of the headlining, a region of the sun visor, a region of the windshield, a region of the window, or a region of a similar location.

The input unit 210 may include a voice input part 211, a gesture input part 212, a touch input part 213, and a mechanical input part 214.

The voice input part 211 may convert a user's voice input into an electrical signal. The electrical signal, resulting from the conversion, may be provided to the processor 270 or the control unit 170. The voice input part 211 may include one or more microphones.

The gesture input part 212 may convert a user's gesture input into an electrical signal. The electrical signal, resulting from the conversion, may be provided to the processor 270 or the control unit 170.

The gesture input part 212 may include at least one of the following: an infrared sensor or an image sensor, each of which serves to detect the user's gesture input. According to an embodiment, the gesture input part 212 may detect a user's three-dimensional (3D) gesture input. To this end, the gesture input part 212 may include a plurality of light-emitting units, each emitting an infrared ray, or a plurality of image sensors.

The gesture input part 212 may detect the user's 3D gesture input through a time-of-flight (TOF) technique, a structured light technique, or a disparity technique.

The touch input part 213 may convert the user's touch input into an electrical signal. The electrical signal, resulting from the conversion, may be provided to the processor 270 or the control unit 170.

The touch input part 213 may include a touch sensor for detecting the user's touch input. According to an embodiment, the touch input part 213 may be integrally formed with a display part 251, thereby forming a touch screen. The touch screen may provide both an input interface and an output interface between the vehicle 100 and the user.

The mechanical input part 214 may include at least one of the following: a button, a dome switch, a jog wheel, or a jog switch. An electrical signal generated by the mechanical input part 214 may be provided to the processor 270 or the control unit 170. The mechanical input part 214 may be arranged on a steering wheel, a center fascia, a center console, a cockpit module, a door, and equivalents thereof.

The internal camera 220 may acquire an image of the interior of the vehicle 100. The processor 270 may detect the user's state on the basis of the image of the interior of the vehicle 100. The processor 270 may acquire the user's gaze information from the image of the interior of the vehicle 100. The processor 270 may detect the user's gesture from the image of the interior of the vehicle 100.

The biometric detection unit 230 may acquire the user's biometric information. The biometric detection unit 230 may include a sensor for acquiring the user's biometric information and may acquire the user's fingerprint information, heart rate information, and equivalents thereof using the sensor. The biometric information may be used for user authentication.

The output unit 250 may generate outputs associated with a visual sense, an auditory sense, a haptic sense, and the like. The output unit 250 may include at least one of the following: a display unit, an audio output unit 252, and a haptic output unit 253.

The term 'display unit' may be used to refer to a vehicular display device 800 according to the present disclosure or to a plurality of displays included in the vehicular display device 800. Alternatively, the vehicular display device 800 according to an embodiment of the present disclosure may also be included as one of the display units.

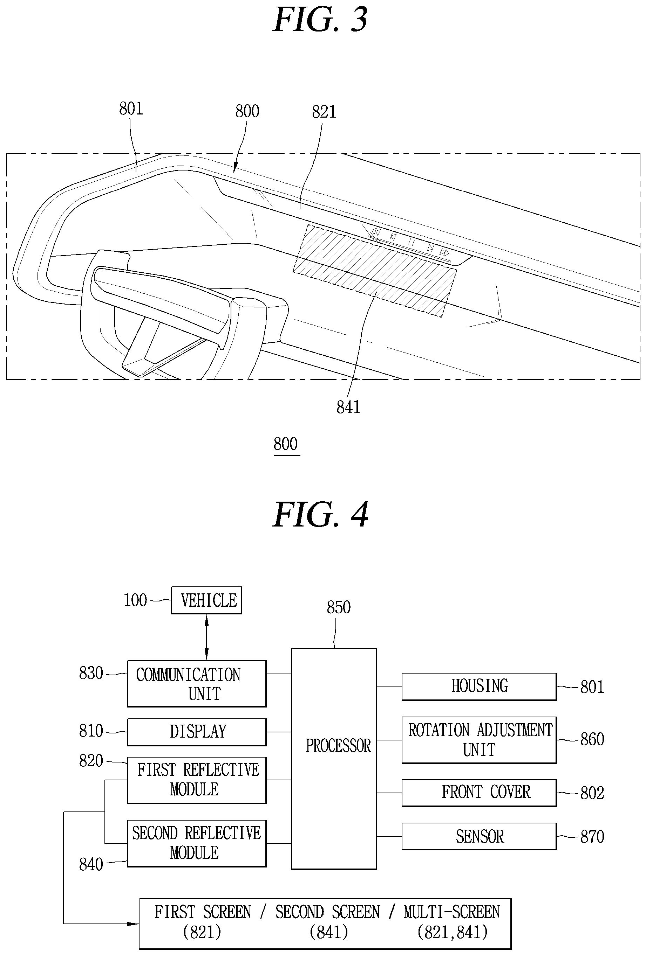

In addition, the term 'user interface device 200' may be interpreted as being functionally and structurally equivalent to the vehicular display device 800 according to the present disclosure. In this case, at least one constituent element included in the user interface device 200 in FIG. 1 may be interpreted as being functionally and structurally equivalent to at least one constituent element of the vehicular display device 800 in FIG. 3.

The display unit may display graphic objects that correspond to various pieces of information. The display module may include at least one of the following: a liquid crystal display (LCD), a thin-film transistor-LCD (TFT LCD), an organic light-emitting diode (OLED), a flexible display, a three-dimensional (3D) display, or an e-ink display.

The display unit may be configured to have a layered structure or an integrated structure with the touch input unit 213, thereby forming a touch screen.

The display unit may be configured as a head-up display (HUD). In a case where the display unit is configured as a HUD, the display unit may include a projection module, thereby outputting information through a windshield or a window.

The display unit may include a transparent display. The transparent display may be attached to the windshield or the window. The transparent display may have a predetermined degree of transparency and may output a predetermined screen thereon. The transparent display may include at least one of the following: a thin-film electroluminescent (TFEL), a transparent organic light-emitting diode (OLED), a transparent liquid crystal display (LCD), a transmissive transparent display, or a transparent light-emitting diode (LED) display. The transparent display may have adjustable transparency.

The user interface device 200 may include a plurality of display units. In this case, the plurality of display units may be positioned in various regions of the vehicle.

The audio output part 252 converts an electrical signal, provided from the processor 270 or the control unit 170, into an audio signal and outputs the audio signal. To this end, the audio output part 252 may include at least one speaker.

The haptic output part 253 generates a tactile output. For example, the haptic output unit 253 vibrates the steering wheel, the safety belt, or the seat, thereby enabling the user to perceive the tactile output.

The processor (hereinafter referred to as a 'control unit') 270 may control the overall operation of each unit of the user interface device 200. That is, the user interface device 200 may operate under the control of the control unit 170.

According to an embodiment, the user interface device 200 may include a plurality of processors 270 or may be configured without the processor 270.

In a case where the processor 270 is not included in the user interface device 200, the user interface device 200 may operate under the control of a processor of another apparatus within the vehicle 100 or under the control of the control unit 170.

The object detection device 300 is a device for detecting an object located outside the vehicle 100. This object may be an external entity associated with driving the vehicle 100. Examples of such an object include a lane, another vehicle, a pedestrian, a two-wheeled vehicle, a traffic signal, a light source, a road, a structure, a speed bump, a terrain feature, an animal, and equivalents thereof.

The objects may be classified into movable objects and stationary objects. Examples of the movable objects may be conceptually represented as including a different vehicle and a pedestrian. Examples of the stationary objects may be conceptually represented as including a traffic light, a road, and a structure.

The object detection device 300 may include a camera 310, a radar 320, a LiDAR 330, an ultrasonic sensor 340, an infrared sensor 350, and a processor 370.

According to an embodiment, the object detection device 300 may further include one or more constituent elements in addition to the constituent elements described in the present specification or may omit one or more of the described constituent elements.

The camera 310 may be located on an appropriate portion of the exterior of the vehicle to capture an image of the surroundings of the vehicle 100. The camera 310 may be a mono camera, a stereo camera 310a, an around-view monitoring (AVM) camera 310b, or a 360-degree camera.

For example, the camera 310 may be arranged adjacent to a front windshield within the vehicle to acquire an image of the surroundings in front of the vehicle. Alternatively, the camera 310 may be arranged in the vicinity of the front bumper or the radiator grill.

For example, the camera 310 may be arranged adjacent to a rear glass pane within the vehicle to capture the image of the surroundings behind the vehicle. Alternatively, the camera 310 may be arranged adjacent to a rear bumper, a trunk, or a tailgate.

For example, the camera 310 may be arranged adjacent to at least one of the side windows within the vehicle to capture an image of the surroundings alongside the vehicle. Alternatively, the camera 310 may be arranged in the vicinity of a side mirror, a fender, or a door.

The camera 310 may provide an acquired image to the processor 370.

The radar 320 may include an electromagnetic wave transmission unit and an electromagnetic wave reception unit. The radar 320 may be configured based on a pulse radar method or a continuous wave radar method, in accordance with the principle of emitting a radio wave. The radar 320 may be configured based on a Frequency Modulated Continuous Wave (FMCW) method or a Frequency Shift Keying (FSK) method, each of which is among continuous wave radar methods determined according to the signal waveform.

The radar 320 may detect an object based on a time-of-flight (TOF) technique or a phase-shift technique through the use of electromagnetic waves and may determine the location of the object, the distance to the object, and the relative speed with respect to the object.

The radar 320 may be arranged in an appropriate position on the exterior of the vehicle 100 to detect an object that is located in front of, behind, or alongside the vehicle 100.

The LiDAR 330 may include a laser transmission unit and a laser reception unit. The LiDAR 330 may be configured based on the time-of-flight (TOF) technique or the phase-shift technique.

The LiDAR 330 may be configured as a drive-type or non-drive-type LiDAR.

In a case where the LiDAR 330 may be configured as a drive-type LiDAR, the LiDAR 330 may be rotated by a motor and may detect an object in the vicinity of the vehicle 100.

In a case where the LiDAR 330 may be configured as a non-drive-type LiDAR, the LiDAR 330 may detect, through light steering, an object located within a predetermined range of the vehicle 100. The vehicle 100 may include a plurality of non-drive-type LiDAR's 330.

The LiDAR 330 may detect an object based on the time-of-flight (TOF) technique or the phase-shift technique through the use of laser light and may determine the location of the object, the distance to the object, and the relative speed with respect to the object.

The LiDAR 330 may be arranged in an appropriate position on the exterior of the vehicle 100 to detect an object that is located in front of, behind, or alongside the vehicle 100.

The ultrasonic sensor 340 may include an ultrasonic wave transmission unit and an ultrasonic wave reception unit. The ultrasonic sensor 340 may detect an object through the use of ultrasonic waves and may determine the location of the object, the distance to the object, and the relative speed with respect to the object.

The ultrasonic sensor 340 may be arranged in an appropriate position on the exterior of the vehicle 100 to detect an object located in front of, behind, or alongside the vehicle 100.

The infrared sensor 350 may include an infrared light transmission unit and an infrared light reception unit. The infrared sensor 340 may detect an object through the use of infrared light and may determine the location of the detected object, the distance to the detected object, and the relative speed with respect to the detected object.

The infrared sensor 350 may be arranged in an appropriate position on the exterior of the vehicle 100 to detect an object located in front of, behind, or alongside the vehicle 100.

The processor 370 may control the overall operation of each unit of the object detection device 300.

The processor 370 may detect and track an object on the basis of an acquired image. The processor 370 may perform operations, such as calculation of the distance to the object and calculation of the relative speed with respect to the object, through the use of an image processing algorithm.

The processor 370 may detect and track an object through the use of reflected electromagnetic waves, resulting from the reflection of emitted electromagnetic waves by the object. The processor 370 may perform operations, such as calculation of the distance to the object and calculation of the relative speed with respect to the object, through the use of electromagnetic waves.

The processor 370 may detect and track an object through the use of reflected laser beams, resulting from the reflection of emitted lasers by the object. The processor 370 may perform operations, such as calculation of the distance to the object and calculation of the relative speed with respect to the object, through the use of laser beams.

The processor 370 may detect and track an object through the use of reflected ultrasonic waves, resulting from the reflection of emitted ultrasonic waves by the object. The processor 370 may perform operations, such as calculation of the distance to the object and calculation of the relative speed with respect to the object, through the use of ultrasonic waves.

The processor 370 may detect and track an object through the use of reflected infrared light, resulting from the reflection of emitted infrared light by the object. The processor 370 may perform operations, such as calculation of the distance to the object and calculation of the relative speed with respect to the object, through the use of infrared light.

According to an embodiment, the object detection device 300 may include a plurality of processors 370 or may be configured without including the processor 370. The camera 310, the radar 320, the LiDAR 330, the ultrasonic sensor 340, and the infrared sensor 350 may include respective processors for individual operation.

In a case where the processor 370 is not included in the object detection device 300, the object detection device 300 may operate under the control of a processor of an apparatus within the vehicle 100 or under the control of the control unit 170.

The object detection device 300 may operate under the control of the control unit 170.

The communication device 400 is a device for performing communication with an external device. The external device here may be a different vehicle, a mobile terminal, or a server.

To perform communication, the communication device 400 may include a transmission antenna, a reception antenna, and at least one of the following: a radio frequency (RF) circuit or an RF device, each of which is capable of implementing various communication protocols.

The communication device 400 may include a short-range communication unit 410, a location information unit 420, a V2X communication unit 430, an optical communication unit 440, a broadcast transceiver 450, and a processor 470.

According to an embodiment, the communication device 400 may further include one or more constituent elements in addition to the constituent elements in the present specification or may omit one or more of the described constituent elements.

The short-range communication unit 410 is a unit for short-range communication. The short-range communication unit 410 may support short-range communication using at least one of the following technologies: Bluetooth^{™}, Radio Frequency IDentification (RFID), Infrared Data Association (IrDA), Ultra-Wide Band (UWB), Zig Bee, Near Field Communication (NFC), Wireless-Fidelity (Wi-Fi), Wi-Fi Direct, or Wireless Universal Serial Bus (USB).

The short-range communication unit 410 may form short-range wireless area networks and may perform short-range communication between the vehicle 100 and at least one external device.

The location information unit 420 is a unit for acquiring location information of the vehicle 100. For example, the location information unit 420 may include a Global Positioning System (GPS) module or a Differential Global Positioning System (DGPS) module.

The V2X communication unit 430 is a unit for performing wireless communication with a server (Vehicle to Infrastructure (V2I)), with another vehicle (Vehicle to Vehicle (V2V)), or with a pedestrian (Vehicle to Pedestrian (V2P)). The V2X communication unit 430 may include an RF circuit capable of implementing protocols for communication with an infrastructure (V2I), communication between vehicles (V2V), and communication with a pedestrian (V2P).

The optical communication unit 440 is a unit for performing communication with the external device through the use of light. The optical communication unit 440 may include an optical transmission part for converting an electrical signal into an optical signal and transmitting the optical signal to the outside, and an optical reception part for converting a received optical signal into an electrical signal.

According to an embodiment, the optical transmission part may be integrally formed with a lamp included in the vehicle 100.

The broadcast transceiver 450 is a unit for receiving a broadcast signal from an external broadcast management server or transmitting a broadcast signal to the broadcast management server over a broadcast channel. The broadcast channel may refer to a satellite channel, a terrestrial channel, or both. The broadcast signal may include a TV broadcast signal, a radio broadcast signal, and a data broadcast signal.

The processor 470 may control the overall operation of each unit of the communication device 400.

According to an embodiment, the communication device 400 may include a plurality of processors 470 or may be configured without including the processor 470.

In a case where the processor 470 is not included in the communication device 400, the communication device 400 may operate under the control of a processor of another apparatus within the vehicle 100 or under the control of the control unit 170.

The communication device 400, together with the user interface device 200, may constitute a vehicular display device. In this case, the vehicular display device may be referred to as a telematics device or an Audio Video Navigation (AVN) device.

The communication device 400 may operate under the control of the control unit 170.

The driving operation apparatus 500 is an apparatus for receiving a user input for driving.

In the manual mode, the vehicle 100 may be driven on the basis of a signal provided by the driving operation apparatus 500.

The driving operation apparatus 500 may include the steering input device 510, an acceleration input device 530, and a brake input device 570.

The steering input device 510 may receive an input regarding the traveling direction of the vehicle 100 from the user. The steering input device 510 is preferably formed in the form of a wheel, thereby enabling a steering input through the rotation of the wheel. According to an embodiment, the steering input device may also be formed in the shape of a touch screen, a touchpad, or a button.

The acceleration input device 530 may receive, from the user, an input for accelerating the vehicle 100. The brake input device 570 may receive, from the user, an input for decelerating the vehicle 100. The acceleration input device 530 and the brake input device 570 are preferably formed in the shape of a pedal. According to an embodiment, the acceleration input device or the brake input device may also be formed in the shape of a touch screen, a touchpad, or a button.

The driving operation apparatus 500 may operate under the control of the control unit 170.

The vehicle drive apparatus 600 is an apparatus that electrically controls the operation of various apparatuses within the vehicle 100.

The vehicle drive apparatus 600 may include a power train drive unit 610, a chassis drive unit 620, a door/window drive unit 630, a safety apparatus drive unit 640, a lamp drive unit 650, and an air-conditioner drive unit 660.

According to an embodiment, the vehicle drive apparatus 600 may further include one or more constituent elements in addition to the constituent elements described in the present specification or may omit one or more of the described constituent elements.

The vehicle drive apparatus 600 may include a processor. Units of the vehicle drive apparatus 600 may include respective processors for individual operation.

The power train drive unit 610 may control the operation of a power train apparatus.

The power train drive unit 610 may include a power source drive part 611 and a transmission drive part 612.

The power source drive part 611 may execute control of a power source of the vehicle 100.

For example, in a case where the power source of the vehicle is a fossil-fuel-based engine, the power source drive part 610 may execute electronic control of the engine. Accordingly, output torque and other parameters of the engine may be controlled. The power source drive part 611 may adjust the engine output torque under the control of the control unit 170.

For example, in a case where the power source of the vehicle is an electric-energy-based motor, the power source drive part 610 may execute control of the motor. The power source drive part 610 may adjust the rotational speed, torque, and other parameters of the motor under the control of the control unit 170.

The transmission drive part 612 may execute control of a transmission. The transmission drive gearbox part 612 may adjust the state of the transmission. The transmission drive part 612 may change the state of the transmission to Drive (D), Reverse (R), Neutral (N), or Park (P).

In a case where the power source of the vehicle is an engine, the transmission drive part 612 may adjust the engaged state of a gear in Drive (D).

The chassis drive unit 620 may control the operation of a chassis apparatus. The chassis drive unit 620 may include a steering drive part 621, a brake drive part 622, and a suspension drive part 623.

The steering drive part 621 may execute electronic control of a steering apparatus within the vehicle 100. The steering drive part 621 may change the traveling direction of the vehicle.

The brake drive part 622 may execute electronic control of a brake apparatus within the vehicle 100. For example, the brake drive part 622 may reduce the speed of the vehicle 100 by controlling the operation of the brakes provided on the wheels.

The brake drive part 622 may individually control each of the plurality of brakes. The brake drive part 622 may control the application of varying braking forces to the plurality of wheels.

The suspension drive part 623 may execute electronic control of a suspension apparatus within the vehicle 100. For example, in a case where a road surface is uneven, the suspension drive part 623 may reduce vibration of the vehicle 100 by controlling the suspension apparatus. The suspension drive part 623 may control each of the plurality of suspensions individually.

The door/window drive unit 630 may execute electronic control of a door apparatus or a window apparatus within the vehicle 100.

The door/window drive unit 630 may include a door drive part 631 and a window drive part 632.

The door drive part 631 may execute control of the door apparatus. The door drive part 631 may control opening or closing of a plurality of doors included in the vehicle 100. The door drive part 631 may control opening or closing of the trunk or the tailgate. The door drive part 631 may control opening or closing of the sunroof.

The window drive part 632 may execute electronic control of the window apparatus. The window drive part 632 may control opening or closing of a plurality of windows included in the vehicle 100.

The safety apparatus drive unit 640 may execute electronic control of various safety apparatuses within the vehicle 100.

The safety apparatus drive unit 640 may include an airbag drive part 641, a seat belt drive part 642, and a pedestrian protection apparatus drive part 643.

The airbag drive part 641 may execute electronic control of an airbag apparatus within the vehicle 100. For example, when a risk is detected, the airbag drive part 641 may control an airbag in such a manner that the airbag is deployed.

The seat belt drive part 642 may execute electronic control of a seat belt apparatus within the vehicle 100. For example, when a risk is detected, the seat belt drive part 642 may secure occupants seated in seats 110FL, 110FR, 110RL, and 110RR by tightening respective seat belts.

The pedestrian protection apparatus drive part 643 may execute electronic control of the hood lift and the pedestrian airbag. For example, when a collision with a pedestrian is detected, the pedestrian protection apparatus drive part 643 may control the hood and the pedestrian airbag in such a manner that the hood is lifted up and the pedestrian airbag is deployed.

The lamp drive part 650 may execute electronic control of various lamp apparatuses within the vehicle 100.

The air-conditioner drive unit 660 may execute electronic control of an air conditioner within the vehicle 100. For example, when the temperature inside the vehicle 100 is high, the air-conditioner drive unit 660 may control the air conditioner to operate in such a manner as to supply cool air into the vehicle 100.

The vehicle drive apparatus 600 may include a processor. Units of the vehicle drive apparatus 600 may include respective processors for individual operation.

The vehicle drive apparatus 600 may operate under the control of the control unit 170.

The operational system 700 is a system that controls various driving functions of the vehicle 100. The operational system 700 may operate in the autonomous driving mode.

The operational system 700 may include the driving system 710, the parking-lot departure system 740, and the parking system 750.

According to an embodiment, the operational system 700 may further include one or more constituent elements in addition to the constituent elements described in the present disclosure or may omit one or more of the described constituent elements.

The operational system 700 may include a processor. Units of the operational system 700 may include respective processors for individual operation.

According to an embodiment, in a case where the operational system 700 may be implemented in software, the operational system 700 may also conceptually operate at a lower level than the control unit 170.

According to an embodiment, the operational system 700 may conceptually include at least one of the following: the user interface device 200, the object detection device 300, the communication device 400, the vehicle drive apparatus 600, or the control unit 170.

The driving system 710 may enable the vehicle 100 to be driven.

The driving system 710 may receive navigation information from the navigation system 770, may provide a control signal to the vehicle drive apparatus 600, and may enable the vehicle 100 to be driven. The driving system 710 may receive object information from the object detection device 300, may provide a control signal to the vehicle drive apparatus 600, and may enable the vehicle 100 to be driven. The driving system 710 may receive a signal from an external device through the communication device 400, may provide a control signal to the vehicle drive apparatus 600, and may enable the vehicle 100 to be driven.

The parking-lot departure system 740 may perform a maneuver to guide the vehicle 100 out of a parking lot.

The parking-lot departure system 740 may receive the navigation information from the navigation system 770, may provide a control signal to the vehicle drive apparatus 600, and may perform a maneuver to guide the vehicle 100 out of the parking lot. The parking-lot departure system 740 may receive object information from the object detection device 300, may provide a control signal to the vehicle drive apparatus 600, and may perform a maneuver to guide the vehicle 100 out of the parking lot. The parking-lot departure system 740 may receive a signal from an external device through the communication device 400, may provide a control signal to the vehicle drive apparatus 600, and may perform a maneuver to guide the vehicle 100 out of the parking lot.

The parking system 750 may perform a maneuver to park the vehicle 100.

The parking system 750 may receive the navigation information from the navigation system 770, may provide a control signal to the vehicle drive apparatus 600, and may perform a maneuver to park the vehicle 100. The parking system 750 may receive object information from the object detection device 300, may provide a control signal to the vehicle drive apparatus 600, and may perform a maneuver to park the vehicle 100. The parking system 750 may receive a signal from an external device through the communication device 400, may provide a control signal to the vehicle drive apparatus 600, and may perform a maneuver to park the vehicle 100.

The navigation system 770 may provide the navigation information. The navigation information may include at least one of the following: map information, information about a preset destination, path information based on the preset destination, information about various objects on a path, lane information, or current vehicular location information.

The navigation system 770 may include a memory and a processor. The navigation information may be stored in the memory. The processor may control the operation of the navigation system 770.

According to an embodiment, the navigation system 770 may update previously stored information by receiving information from an external device through the communication device 400.

According to an embodiment, the navigation system 770 may also be classified as a sub-constituent element of the user interface device 200.

The sensing unit 120 may sense the state of the vehicle. The sensing unit 120 may include a posture sensor (e.g., a yaw sensor, a roll sensor, or a pitch sensor), a collision sensor, a wheel sensor, a speed sensor, a tilt sensor, a weight-detection sensor, a heading sensor, a yaw sensor, a gyro sensor, a position module, a vehicle forward/backward movement sensor, a battery sensor, a fuel sensor, a tire sensor, a steering sensor sensing the turning of a steering wheel, an in-vehicle temperature sensor, an in-vehicle humidity sensor, an ultrasonic sensor, an illumination sensor, an accelerator position sensor, a brake pedal position sensor, and other sensors.

The sensing unit 120 may acquire vehicular posture information, vehicular collision information, vehicular direction information, vehicular location information (GPS information), vehicular angle information, vehicular speed information, vehicular acceleration information, vehicular tilt information, vehicular forward/backward movement information, battery information, fuel information, tire information, vehicular lamp information, in-vehicle temperature information, and in-vehicle humidity information. Furthermore, the sensing unit 120 may acquire signals that result from sensing a steering wheel rotation angle, vehicle exterior illumination, pressure applied to an acceleration pedal, pressure applied to a brake pedal, and equivalents thereof.

The sensing unit 120 may further include an acceleration pedal sensor, a pressure sensor, an engine speed sensor, an air flow sensor (AFS), an air temperature sensor (ATS), a water temperature sensor (WTS), a throttle position sensor (TPS), a TDC sensor, a crank angle sensor (CAS), and other sensors.

The vehicular interface unit 130 may serve as an interface for various types of external devices connected to the vehicle 100. For example, the vehicular interface unit 130 may include a port that enables a connection to a mobile terminal and may be connected to the mobile terminal through the port. In this case, the vehicular interface unit 130 may exchange data with the mobile terminal.

The vehicular interface unit 130 may serve as an interface for supplying electrical energy to the connected mobile terminal. In a case where the mobile terminal is electrically connected to the vehicular interface unit 130, the vehicular interface unit 130 may supply electrical energy, supplied from the power supply unit 190, to the mobile terminal under the control of the control unit 170.

The memory 140 is electrically connected to the control unit 170. Basic data for the units, control data for controlling operations of the units, and input and output data may be stored in the memory 140. Examples of the memory 140 may include various hardware storage devices, such as ROM, RAM, EPROM, flash memory, and a hard disk drive. Programs and equivalents thereof for processing or control by the control unit 170 and various data for the overall operation of the vehicle 100 may be stored in the memory 140.

According to an embodiment, the memory 140 may be integrally formed with the control unit 170 or may be configured as a sub-constituent element of the control unit 170.

The control unit 170 may control the overall operation of each unit within the vehicle 100. The control unit 170 may be referred to as an Electronic Control Unit (ECU).

The power supply unit 190 may supply power necessary for the operation of each constituent element under the control of the control unit 170. Specifically, the power supply unit 190 may be supplied with power from the battery within the vehicle 100 or from other sources.

At least one processor and at least one control unit 170, which are included in the vehicle 100, may be configured based on at least one of the following: application-specific integrated circuits (ASICs), digital signal processors (DSPs), digital signal processing devices (DSPDs), programmable logic devices (PLDs), field-programmable gate arrays (FPGAs), processors, controllers, microcontrollers, microprocessors, or electric units performing other functions.

The vehicular display device 800 according to the present disclosure may form an aerial image and a real image in a plurality of different types of screen regions using a single display module. In addition, through the combination of a plurality of screen regions, a multi-display effect can be achieved using a single display module.

FIG. 3 is a view illustrating an example in which the vehicular display device 800 according to the present disclosure operates after installation.

The vehicular display device 800 may be installed in such a manner as to correspond to the dashboard in front of a driver's seat of the vehicle 100, or may be installed in a rectangular shape extending from the dashboard in front of the driver's seat to a front passenger seat.

The vehicular display device 800 includes a housing 801 recessed to form an inner space inside, and a display may be arranged on one side of the inner space in the housing 801. For example, the display of the vehicular display device 800 may be arranged in the upper portion of the inner space in the housing 801, with a front surface of the display facing downward.

The housing 801 is formed to be recessed inward to have an inner space, thereby naturally forming a dark space. Accordingly, real and virtual images may be more clearly displayed on the first and second screen regions formed by first and second reflective modules 820 and 840, respectively.

The housing 801 may be formed such that the inner side of the inner space is closed and the outer side facing the driver's seat is open. In addition, the housing 801 may be formed such that the inner space decreases in width as it extends inward and increases in width as it extends outward.

A plurality of screen regions may be formed in the inner space in the housing 801 by operating the display. In an embodiment, some of the plurality of screen regions may be formed to extend outward from the housing 801.

The plurality of screen regions may include a first screen region 821 formed in the upper portion of the inner space in the housing 801 and a second screen region 841 under the first screen region 821.

The first screen region 821 is a prism screen region that is formed by a graphic displayed in a region of the display undergoing refraction through a prism, and a real image may be displayed on the first screen region 821. In addition, the second screen region 841 is a floating screen region in which a graphic displayed in another region of the display is formed after reflection through a 3D plate, and an aerial image may be output on the second screen region 841.

In the prism screen region, for example, a real image, resulting from polarized light refracted through a prism being reflected by a mirror, may be displayed above the prism. In addition, a 3D aerial image (AR) based on graphic light of the display that is reflected by the 3D plate may be displayed in the inner space of the recessed housing 801 or may be displayed with at least one portion thereof extending outward from the inner space. In the former case, the prism screen region and the floating screen region are arranged on the same plane, whereas in the latter case, these screen regions may not be arranged on the same plane.

The first screen region 821 may be formed only at a position corresponding to the driver's seat or may be formed to correspond to the driver's seat and the front passenger seat. The second screen region 841 may be formed at a position corresponding to the driver's seat and the front passenger seat.

The first screen region 821 and the second screen region 841 may be selectively formed or simultaneously formed. In a case where the first and second screen regions 821 and 841 are formed together, associated content items may be displayed as different types of images, for example, as a real image and an aerial image.

FIG. 4 is an exemplary block diagram that is referenced to describe the detailed configuration of the vehicular display device 800 according to the present disclosure.

The vehicular display device 800 may include a housing 801, a display 810, a communication unit 830, a first reflective module 820, a second reflective module 840, a processor 850, a rotation adjustment unit 860, and a sensor 870. In addition, the vehicle control device 800 may communicate with the vehicle 100 through the communication unit 830. In addition, the vehicular display device 800 may be configured to form the first screen region 821, the second screen region 841, and/or the multi-screen region indicated by 821 and 841 through the first reflective module 820 and/or the second reflective module 840.

The housing 801 constitutes a frame of the vehicular display device 800 and is formed to be recessed to form an inner space inside.

The display 810 may be arranged on one side of the inner space in the housing 801, for example, in the upper portion of the inner space. At this point, a rear surface of the display 810 is coupled to a ceiling of the inner space in the housing 801, and a front surface of the display 810 may be arranged to face the floor.

The display 810 may be arranged to be inclined at a predetermined angle in such a manner as not to be parallel to the floor. To this end, the ceiling of the inner space in the housing 801 may be formed to be inclined at a predetermined angle relative to the floor. In this manner, the display 810 is formed to be inclined at a predetermined angle relative to the floor. Thus, a floating effect of the 3D AR image displayed in the second screen region formed through the second reflective module 840 is further maximized.

The communication unit 830 may receive a vehicle state and data related to vehicle driving from the vehicle 100 in which the vehicular display device 800 is installed. In addition, the communication unit 830 may transmit an operational state of the vehicular display device 800 and data related to the operation of the vehicular display device 800 to the vehicle 100. To this end, the communication unit 830 may be configured to include both a transmission module and a reception module or to include a transceiver capable of both transmission and reception.

The first reflective module 820 may be arranged to be coupled to one side of the display 810 in the inner space in the housing 801. The first reflective module 820 may be arranged in such a manner that graphic light emitted from a first region of the display 810 undergoes refraction to form the first screen region. The first screen region refers to a prism region in which a real image of linearly polarized light is displayed, the linearly polarized light corresponding to a graphic of the display 810 that undergoes refraction through the prism. The 'first screen region' may be hereinafter referred to as a 'prism display,' a 'prism screen,' or a 'prism screen region.'

The first reflective module 820 may include a prism and a reflection plate to form the first screen region. The first screen region may be formed above the second screen region described below, and the graphic light emitted from the first region of the display 810 may be output as a real image.

The second reflective module 840 may be arranged to be coupled to one side of the first reflective module 820 in the inner space in the housing 801. The second reflective module 840 may be arranged such that graphic light emitted from the second region of the display 810 is reflected to form the second screen region. The second screen region is connected to the first screen region and defines an AR floating region in which a virtual (AR) image is displayed in the inner space in the housing 801. The 'second screen region' may be referred to as a 'floating region,' a 'floating screen,' 'a floating display,' a 'floating screen region,' an 'aerial-image screen region,' or an 'AR floating region.'

The second reflective module 840 may include a 3D plate and a reflection plate to form the second screen region. At this point, the second screen region may be formed below the first screen region. Thus, graphic light emitted from the second region of the display 810 may be output as an aerial image, that is, as a 3D AR image.

The processor 850 generally operates the display 810, the first reflective module 820, and the second reflective module 840. The processor 850 may be arranged on an inner side of the inner space in the housing 801 or on an outer side of a rear surface of the housing 801.

The processor 850 may control whether to operate the display 810 based on the startup of the vehicle or on a request. When operating the display 810, by controlling the operation of the first reflective module 820 and/or the second reflective module 840, the processor 850 may control the display 810 in such a manner that a graphic displayed on the display 810 appears as a real image or an aerial image through the first screen region and/or the second screen region.

When operating the display 810, the processor 850 may determine whether to activate the first and second screen regions by controlling at least one of the first and second reflective modules 820 and 840 according to a preset condition. Accordingly, an occupant in the vehicle 100 may view a graphic displayed on the display 810 at the first screen region, the second screen region, or the multi-screen region.

The processor 850 may control a change in a position of the second screen region formed through the second reflective module 840 by controlling the operation of the rotation adjustment unit 860. The rotation adjustment unit 860 may also be implemented as a function of the processor 850.

The rotation adjustment unit 860 may control the rotation of the second reflective module 840 in such a manner as to change a reflection angle and an optical path length between the second reflective module 840 and the display 810. To this end, the second reflective module 840 may be rotatably coupled to a rotation driving unit at one side of the rotation adjustment part 860.

The rotation of the second reflective module 840 may be adjusted in accordance with the operation of the rotation adjustment unit 860, thereby allowing the position of the second screen region formed through the second reflective module 840 to be varied. Accordingly, a 3D virtual image displayed in the second screen region may move backward or forward.

The rotation adjustment unit 860 may be configured to include a coupling unit for coupling to the second reflective module 860, a rotation unit for rotating the second reflective module 860, and a support unit for supporting a plate during the rotation of the second reflective module 860.

The sensor 870 may include a sensor for detecting an input to the display 810 and a sensor for detecting a (hovering) input to the first and second screen regions. In addition, the sensor 870 may further include a camera sensor, an IR sensor, an IMS sensor, or the like for recognizing an entity performing an input or monitoring a state of an occupant in the driver's seat or the front passenger seat.

In some embodiments, the sensor 870 may include a camera sensor, an IR sensor, and an IMS sensor for the vehicle. The vehicular display device 800 may recognize an occupant's field of view through the sensor 870 and may transmit information about the occupant's field of view to the processor 850. Then, the processor 850 may adjust a position where the second screen region is formed, by changing the position of the second reflective module 840 based on the occupant's field of view.

The vehicular display device 800 may further include a front cover 802. In this case, the front cover 802 may be closed to conceal the inner space in the housing 801 from being visible when the display 810 is not in operation, and may operate to expose the inner space in the housing 801 when the display 810 is in operation.

In this manner, the vehicular display device 800 according to the embodiment of the present disclosure refracts a portion of a graphic emerging from one display 810 arranged on one side of the inner space in the housing 801 through the first reflective module, and reflects another portion through the second reflective module. By doing so, the vehicular display device 800 may realize complex content including an aerial image and a real image selectively or simultaneously using a single display module.

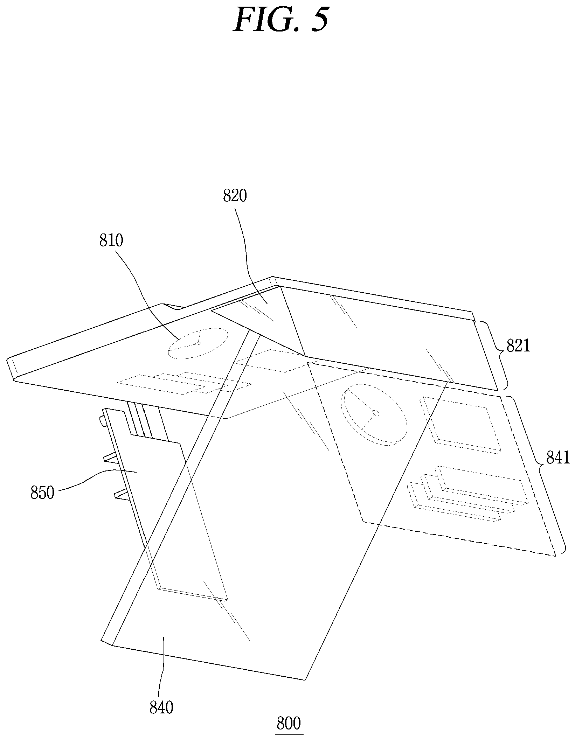

FIG. 5 is a perspective view illustrating the vehicular display device 800 according to the present disclosure. Specifically, FIG. 5 is a view illustrating one 'package' configuration of the vehicular display device 800 for outputting a graphic displayed on a single display, arranged in an upper portion, through the prism screen and the floating screen, when viewed from the side.

A display 810 inclined at a predetermined angle relative to the floor may be arranged in an upper portion of the package. That is, the display 810 may be arranged in the upper portion in a manner tilted at a predetermined angle so as not to be parallel with the floor. Accordingly, the floating effect of the 3D virtual image displayed in the floating region formed through the second reflective module 840 described below may be expressed in a more three-dimensional and prominent manner. In addition, by arranging the front surface of display 810 to face the floor, light-emitting graphic light emerges from the front surface of display 810 in a vertical direction when the display 810 is in operation.

The processor 850, for example, a PCB, for controlling the operation of the vehicular display device 800 is arranged at the rear side of the package. The processor 850 controls the operation of the display 810, whether to activate the first and second reflective modules 820 and 840, and the operation of the first and second reflective modules 820 and 840. The processor 850 may be electrically coupled to one side of the display 810 and may be arranged to be positioned perpendicularly to the display 810 arranged in the upper portion.

The first reflective module 820 may operate to refract graphic light emerging from a region of the display 810 through a prism coupled vertically to one side of the display 810, thereby displaying a real image on the prism.

A prism of the first reflective module 820 is a refractive body fabricated from a transparent transmissive material at precise angles and planes. The prism changes an optical path by redirecting graphic light output to the first region of the display 810. The first reflective module prism 820 is arranged to be positioned perpendicularly to the display 810, and, for example, may have the shape of a triangular prism. Accordingly, the graphic light output to the first region of the display 810 is refracted, and consequently, the first screen region (or the prism region) 821 may be formed on a surface of a prism that is positioned perpendicularly to the display 810. In an embodiment, depending on the number of reflective mirrors coupled to the prism, an image of a graphic output to the first of the display 810 is either inverted or displayed in the same shape in the first screen region.

The second reflective module 840 is coupled to one side of the first reflective module 820 and includes the 3D plate arranged to be positioned at a predetermined angle relative to the display 810. The 3D plate, for example, a 3D hologram plate, may reflect graphic light emerging from another region of the display 810, for example, the second region, thereby displaying an aerial image, that is, a 3D virtual image, at a position corresponding to the occupant's field of view.

At this point, the first screen region formed through the first reflective module 820 and the second screen region formed through the second reflective module 840 have different depths. Specifically, the first screen region 821 is formed on a front surface of the prism of the first reflective module 820, whereas the second screen region 841 is formed in a 3D space that is formed by reflection through the 3D plate of the second reflective module 840. At this point, a portion of the second screen region may be positioned on the same plane as the first screen region.

The package may be arranged within the housing 801 (FIG. 4) recessed to form an inner space. Along with the housing structure 801, the second reflective module 840 reflects graphic light emitted from the display 810 through the 3D hologram plate, thereby forming an image at the lower end portion. This inherently obstructs external light.

Although not illustrated, the package may further include a light absorption unit for absorbing the graphic light emerging from the display 810, and a backplate coupled to a rear surface of the 3D plate of the second reflective module 840.

At this point, a material of the backplate may be an ultra-thin glass (UTG) and can perform a function of supporting the 3D hologram plate from the rear surface.

In addition, the light absorption unit is arranged to form a darkroom on the left and right sides of the housing 801 and may absorb light resulting from the graphic light emitted from the display 810 being scattered by reflection. The light absorption unit reduces the reflection luminance of the graphic light, thereby improving the contrast ratio of the 3D virtual image displayed on the second screen region 841.

The processor 850 of the package may control the second reflective module 840 in such a manner that the 3D plate thereof is rotated to change an inclination angle between the 3D plate and the display 810. The position of the 3D virtual image displayed in the second screen region 841 may be changed based on the change in the angle between the 3D plate of the second reflective module 840 and the display 810, the change being induced by the rotation of the 3D plate. To this end, one side of the second reflective module 840 is coupled to the rotation adjustment unit 860 (FIG. 4) so that the second reflective module 840 may be driven in response to a signal transmitted from the processor 850 in such a manner as to rotate the 3D plate thereof.

In some embodiments, the package may have a rotatable structure or include a driving cover such that the configuration of the package is in a closed state when the display 810 is not in operation and that at least one of the first and second screen regions 821 and 841 formed through the first and second reflective modules 820 and 840, respectively, may be exposed when the display 810 is in operation.

Subsequently, with reference to FIG. 5, the package is arranged within the housing 801 recessed to form an inner space in such a manner that the floating region formed through the second reflective module 840 may be displayed within the inner space.

In addition, as described above, a portion of the floating region that has a changed position when the 3D plate of the second reflective module 840 is rotated may be displayed outward from the inner space formed by the recess of the housing 801. Accordingly, a portion of the 3D floating content displayed in the floating region may be image-formed outward from the inner space formed by the recess of the housing 801.

The vehicular display device 800 reflects/refracts the graphic light emitted from the display 810, arranged in the upper portion, through the prism and the 3D plate that are the first and the second reflective modules 820 and 840, respectively, thereby forming a 3D virtual image and a 3D real image at the prism region 821 and the floating region 841, respectively. Consequently, the real image and the aerial image may be realized independently or simultaneously using a single display.

The graphic light emitted from the display 810 may be refracted through one or more lenses and prisms to form an eye box. To this end, an incident optical module for forming a curvature and an optical path may be further included. For example, a lens and a prism may be arranged at a predetermined angle (e.g., a right angle) relative to the display so as to have a curvature and an optical path for forming an eye box for a graphic displayed in the first region of the display 810.

In addition, the graphic light emitted from the display 810 may be reflected through the 3D plate and the reflective mirror, thereby forming an eye box for displaying an aerial image. At this point, the combiner for compensating for chromatic aberration and adjusting a focal length may be coupled. The combiner may include a 3D plate, which serves to reflect the emitted graphic light refracted through the prism, and a reflective mirror. An example of the 3D plate is a 3D hologram plate.

At this point, the reflective mirror may be configured in the form of a flat plate or a film. A reflective surface of the reflective mirror is formed on a portion of a front surface of the 3D plate, the portion facing the user's eyes, thereby compensating for the chromatic aberration and adjusting the focal length. In addition, according to the present disclosure, since the graphic light of the display 810 arranged in the upper portion of the package is emitted to the 3D plate either after being refracted through the prism or directly, the chromatic aberration due to the separation of a wavelength hardly occurs.

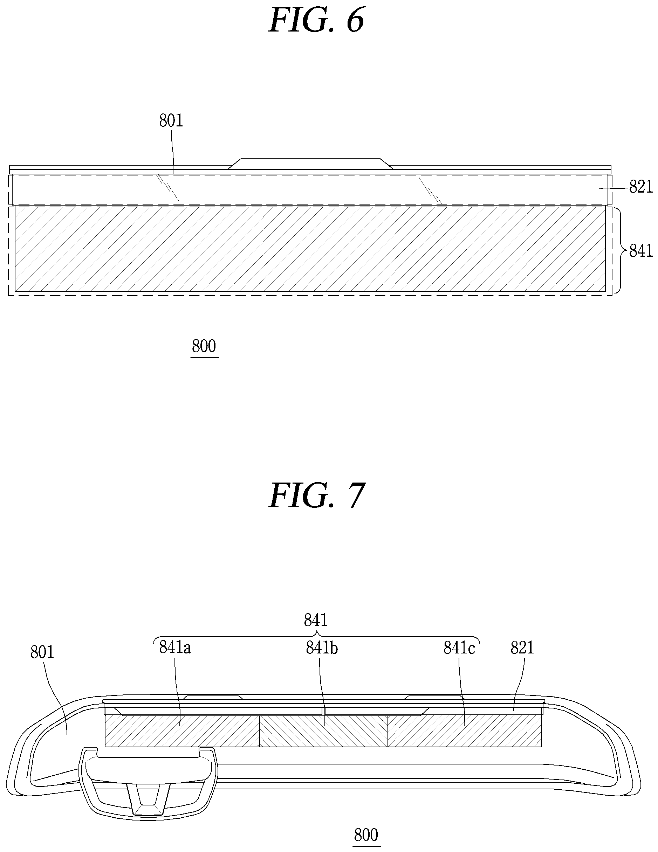

FIG. 6 is a cross-sectional view illustrating a state where the prism display region 821 and the floating display region 841 are formed when the vehicular display device 800 operates, when viewed from the side.

As illustrated in FIG. 6, the prism display region 821 may be formed in the upper portion of the inner space formed by the recess of the housing 801, and the floating display region 841 may be formed in the lower portion of the inner space formed by the recess of the housing 801.

The floating display region 841 may be formed to have a greater size than the prism display region 821. A real image may be displayed on the prism display region 821, and an aerial image having depth, that is, a 3D AR image, may be displayed on the floating display region 841.

The prism display region 821 and the floating display region 841 may be used selectively or may operate simultaneously.

To this end, when operating the display 810, the processor 850 of the vehicular display device 800 controls the operation of at least one of the first and second reflective modules 820 and 840 according to a predetermined condition. By doing so, the processor 850 may determine whether to activate the first and second screen regions, that is, the display region 821 and the floating display region 841.

At this point, the predetermined condition is associated with a driving state of the vehicle 100 in which the vehicular display device 800 is installed. For example, the predetermined conditions may correspond to various situations where a warning or alarm is required based on the driving state of the vehicle.

The processor 850 may activate the first reflective module 820 based on information related to the driving state of the vehicle, the information being received through the communication unit 830, while the vehicle is in a first driving state, thereby displaying a vehicle driving situation in the prism display region 821.

At this point, the first driving state refers to a normal driving state after vehicle ignition, representing a general driving situation where no warning or alarm is required.

Subsequently, when the vehicle transitions from the first driving state to a second driving state according to the information related to the driving state of the vehicle, the information being received through the communication unit 830, the first and second reflective modules 820 and 840 may be activated. By doing so, the first and second reflective modules 820 and 840 may be controlled in such a manner that the vehicle driving situation is displayed in the prism display region 821 and the AR floating display region 840.

At this point, the second driving state refers to a state where a driving situation requiring a warning or alarm occurs during vehicle driving. For example, the processor 850 may initiate a transition to the second driving state in a case where a warning or alarm is necessary due to the vehicle's regulation speed violation, a sharp curve ahead, or the appearance of an object around the vehicle. Furthermore, when the situation is cleared, the processor 850 may initiate a transition back to the first driving state.

In addition, according to the information related to a vehicle driving state, the information being received through the communication unit 830, the second reflective module 840 may be activated while the vehicle 100 is in a third driving state. By doing so, the second reflective module 840 may be controlled in such a manner that the AR virtual image is displayed in the AR floating display region 840 and that a graphic object related to the AR virtual image is displayed in the prism display region 821.

At this point, the third driving state may refer to a state where an entertainment function is performed while the vehicle is in a stopped state.

In another embodiment, the processor 850 of the vehicular display device 800 may determine to display one or both of the prism display region 821 and the AR floating display region 840, depending on the type of content output to the display 810. For example, the type of content related to a state of the vehicle may be displayed on the prism display region 821, and the type of entertainment content may be displayed in the AR floating display region 840.

In addition, in another embodiment, the processor 850 of the vehicular display device 800 may determine to display one or both of the prism display region 821 and the AR floating display region 840 based on the user's input or request.

As described above, the vehicular display device 800 according to the embodiment of the present disclosure may selectively provide a usage environment of a plurality of displays using a single display.

FIG. 7 is an exemplary view that is referenced to describe a plurality of display regions in accordance with a display mode of the vehicular display device 800.

According to a preset condition, the vehicular display device 800 may operate in a 'prism display mode' to display a real image in the prism screen region, may operate in a 'floating display mode' to display an aerial image in the floating screen region, or may operate in a 'multi-display mode' to simultaneously display a real image and a virtual image in the prism screen region and the floating screen region, respectively.

At this point, as described above, the preset condition may be related to the driving state of the vehicle, may be associated with the type of content to be image-formed, or may correspond to the user's input or request.

The vehicular display device 800 may control the second reflective module 840 in such a manner that the floating screen region 841 formed through the second reflective module 840 is displayed, in the inner space formed by the recess of the housing 801, at a position corresponding to each of the driver's seat and the front passenger seat.

Specifically, with reference to FIG. 7, the floating screen region 841 may be divided into a first floating region 841a positioned to correspond to the driver's seat, a third floating region 841c positioned to correspond to the front passenger seat, and a second floating region 841b positioned to correspond to the space between the driver's seat and the front passenger seat.

The first floating region 841a may be a region used by an occupant in the driver's seat, and the third floating region 841c may be a display region used by the occupant in the front passenger seat. In addition, the second floating region 841b may be a display region commonly used by the occupants in the driver's seat and the front passenger seat.

A 3D AR image that floats to correspond to the occupant's field of view in the driver's seat is displayed in the first floating region 841a. In addition, a 3D AR image that floats to correspond to the occupant's field of view in the front passenger seat is displayed in the third floating region 841c. In addition, a 3D AR image that floats to correspond to a preset field of view, for example, a field of view preset to correspond to the driver's seat or a field of view preset to correspond to the front passenger seat, is displayed in the second floating region 841b.

Content items, displayed in the first, second, and third floating regions 841a, 841b, and 841c, may be controlled independently for display.

In addition, a switchable privacy mode (SPM) may be executed in such a manner that the first floating region 841a is not visible from the front passenger seat and that content displayed in the third floating region 841c is not visible from the driver's seat. At this point, 3D content may be displayed in the second floating region 841b within a field of view visible from both the driver's seat and the front passenger seat.

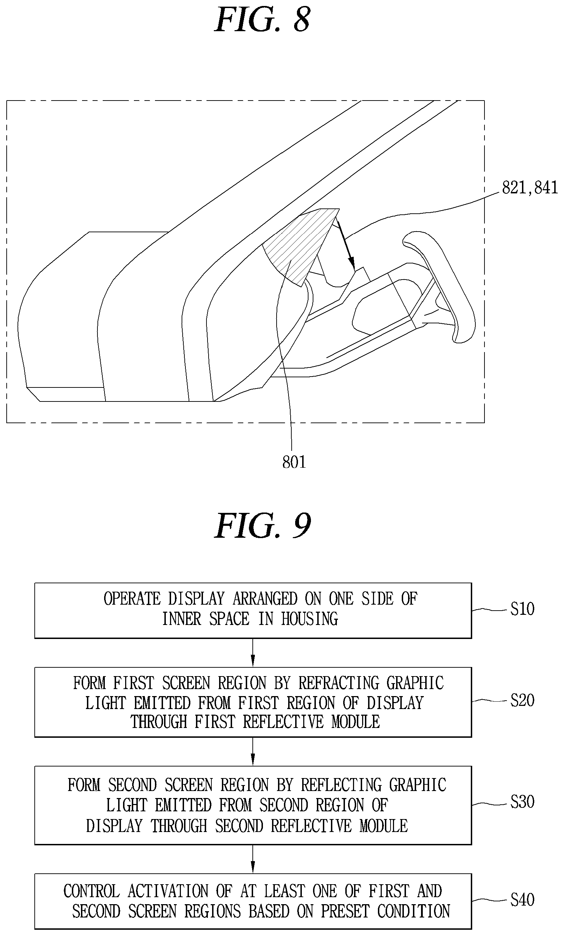

FIG. 8 is a view illustrating the vehicular display device 800 arranged in a cluster or CID region of the vehicle 100 according to the present disclosure, when viewed from the side. As illustrated in FIG. 8, the housing 801 of the vehicular display device may be arranged at a position corresponding to the dashboard in front of the driver's seat. The housing 801, for example, may be formed to be recessed inward to have an inner space in such a manner as to have a volume of approximately 23 liters.

Although not illustrated in detail, when the vehicular display device 800 is in operation, the prism display region 821 in which a real image is displayed, and the floating display region 841 in which an aerial image, that is, a 3D AR image is displayed may be formed in the inner space in the housing 801 that is exposed within the occupant's field of view, thereby providing an eye box for the user.

When the vehicular display device 800 is not in operation, the housing 801 may be rotated or covered by the front cover so that the inner space of housing 801 is hidden from view.

The vehicular display device 800 may selectively activate the prism display region 821 and the floating display region 841 to direct the graphic light emitted from the display 810, which is arranged in the upper portion of the inner space in the housing 801, toward the user's field of view.

To this end, the vehicular display device 800 may control the display 810 in such a manner that the graphic light emitted from the first region of the display 810 is retracted through the prism and thus that a real image is displayed on the surface of the prism.

In addition, the vehicular display device 800 may control the display 810 in such a manner that the graphic light emitted from the second region of the display 810 is retracted through the prism, reflected by the 3D plate, and passes through a reflective polarized plate and/or an absorption-type polarized plate, and thus that a 3D AR image is displayed in the inner space in the housing 801 that matches the eye level of the user.

FIG. 9 is an exemplary flowchart that is referenced to describe a method of operating the vehicular display device 800 according to the present disclosure.

With reference to FIG. 9, the method of operating the vehicular display device 800 according to the embodiment of the present disclosure starts with a step of operating the display arranged on one side of the inner space in the housing 801 (FIG. 4) (S10). Graphic light is emitted from the front surface when the display 810 is in operation.

To this end, the display 810 of the vehicular display device 800 may be arranged in such a manner that the front surface faces toward the ground in the upper portion of the inner space in the housing 801, but may be formed to have a structure configured with a slope non-parallel with the ground.

In this manner, the display 810 is arranged in the inner upper portion of the inner space in the housing 801, thereby enabling the emitted graphic light to have a curvature and an optical path for forming an eye box. Accordingly, the optical path is formed in such a manner that the graphic light emitted from the display 810 is directed toward the 3D plate of the second reflective module 840 without being dispersed.

In addition, since the display 810 to be arranged in the upper portion is formed to have a structure inclined instead of being parallel to the ground, the floating effect of the 3D AR image appearing in the floating display region 841 formed through the second reflective module 840 is maximized.

Subsequently, the vehicular display device 800 may operate such that the graphic light emitted from the first region of the display 810 is reflected by the first reflective module 820, thereby forming the first screen region (S20).

In addition, the vehicular display device 800 may operate such that the graphic light emitted from the second region of the display 810 is reflected by the second reflective module 840, thereby forming the second screen region (S30).

In this manner, the formation of the first and second screen regions may indicate that image formation of the graphic light, emitted by operating the display 810, in any one of the first and second screen regions is completely prepared.

In this manner, when image formation in one or all of a plurality of screen regions is completely prepared, depending on whether a preset condition is satisfied, the display device 800 may control the first and second reflective modules 820 and 840 in such a manner that at least one of the first and the second screen regions formed through the first and second reflective modules 820 and 840 is activated (S40).

Specifically, for example, the first screen region formed through the first reflective module 820 may be activated to display only the vehicle driving state, thereby displaying a real image on the surface of the prism. In addition, for example, the second screen region formed through the second reflective module 840 may be activated to display a warning or alarm or to provide guidance on a hazardous situation, thereby displaying the floating 3D AR image in the inner space formed by the recess of the housing 801. At this point, the inner space formed by the recess of the side-closed housing 801 may naturally provide a darkroom effect, thereby display the floating 3D AR image more clearly.

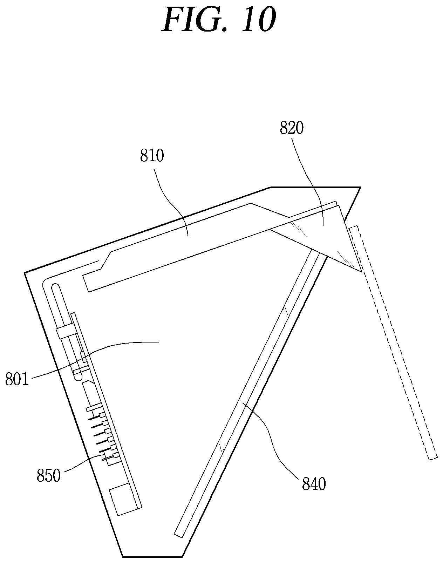

FIGS. 10, 11, and 12 are views illustrating exemplary structures of the vehicular display device 100 for executing a plurality of display modes using a single display, according to an embodiment of the present disclosure.

FIG. 10 illustrates a basic structure of the housing 801 of the vehicular display device 800. In the basic structure, the display 810 may be arranged in the upper portion of the inner space formed by the recess of the housing 801, and the processor 850 may be arranged in a rear portion of the inner space. In addition, the first reflective module 820, which is coupled to one side of the display 810 and includes the prism, is arranged to be perpendicular to the display 810 so as to align with the perpendicular direction in which light is emitted from the display 810. In addition, the second reflective module 840, which is coupled to one side of the first reflective module 820 and by which light refracted while passing through the prism of the first reflective module 820 is reflected, may be arranged to form a predetermined angle relative to the display 810. At this point, the second reflective module 840 may be formed to include a 3D hologram plate and a reflective mirror (not illustrated) that are arranged in the inner space in the housing 801 and formed to face the front surface of the display 810.

In an embodiment, in a state where the first reflective module 820 is activated, the processor 850 may control the first reflective module 820 in such a manner that the prism thereof refracts linearly polarized light corresponding to a graphic, the linearly polarized light being emitted from the first region of the display 810, thereby forming the first screen region.

In addition, in a state where the second reflective module 840 is activated, the processor 850 may control the second reflective module 840 in such a manner that the 3D plate thereof reflects the graphic light emitted from the second region of the display 810 or the linearly polarized light refracted through the prism, thereby forming the second region in which the 3D virtual (AR) image is displayed.

The first screen region formed through the first reflective module 820 is configured to extend over the second screen region formed through the second reflective module 840 and to the first region of the display 810.

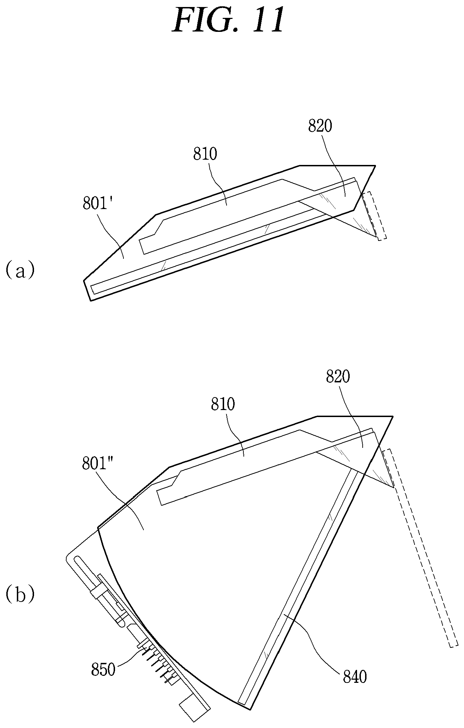

In addition, the second screen region formed through the second reflective module 840 is formed below the first screen region formed through the first reflective module 820. 3D AR content displayed in the second screen region may be formed only within the inner space of housing 801 or may be partially formed to extend outward from the inner space.
(a) of FIG. 11 illustrates an exemplary structure used only in the first screen region that is formed through the prism of the first reflective module 820 when the display 810 of the vehicular display device 800 operates. The volume of a housing 801' may be minimized in a state where, as illustrated in (a) of FIG. 11, the 3D hologram plate is folded or rotated in parallel with the display 810. The structure of the housing 801' may be referred to as a minimum slim package, and the graphic light emitted from the display 810 is refracted through the prism and is displayed as a real image on the front surface thereof. For example, in a case where the 3D hologram plate of the second reflective module is rotated, and thus an inner space in the housing 801' is reduced to the minimum, the volume of the minimum slim package may change to 9 liters.
(b) of FIG. 11 illustrates a state where the first and second reflective modules 820 and 840 both operate when the display 810 of the vehicular display device 800 operates and where the first and second screen regions are correspondingly activated. At this point, the processor 850 may be arranged on an outer rear portion of the housing 801'' in such a manner as to be coupled to one side of the display 810.

In addition, according to an embodiment, a UTG plate may be coupled to the front surface of the 3D plate of the second reflective module 840, thereby forming an optical path for an eye box. In addition, although not illustrated, a light absorption plate may further be included. The light absorption plate is adjacent to the 3D plate of the second reflective 840 and additionally absorbs linearly polarized light not reflected by the 3D plate.

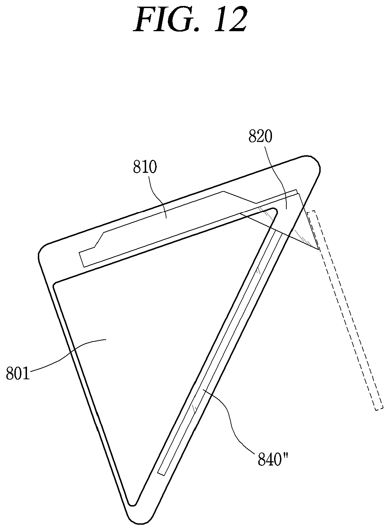

Subsequently, with reference to FIG. 12, the package of the vehicular display device 800 may be formed on the dashboard in a manner integrated with an air duct of the driver's seat of the vehicle 100, thereby having a slimmed structure. In this manner, in a case where the package is modularized with an air purifier of the vehicle, the package and the housing may be configured to have a volume of 11 liters, which is greater than the volume of the above-described minimum slim package.

As described above, in the embodiments, the vehicular display device 800 according to the embodiment of the present disclosure has the structures in which different types of graphics are displayed in the plurality of display regions using a single display.

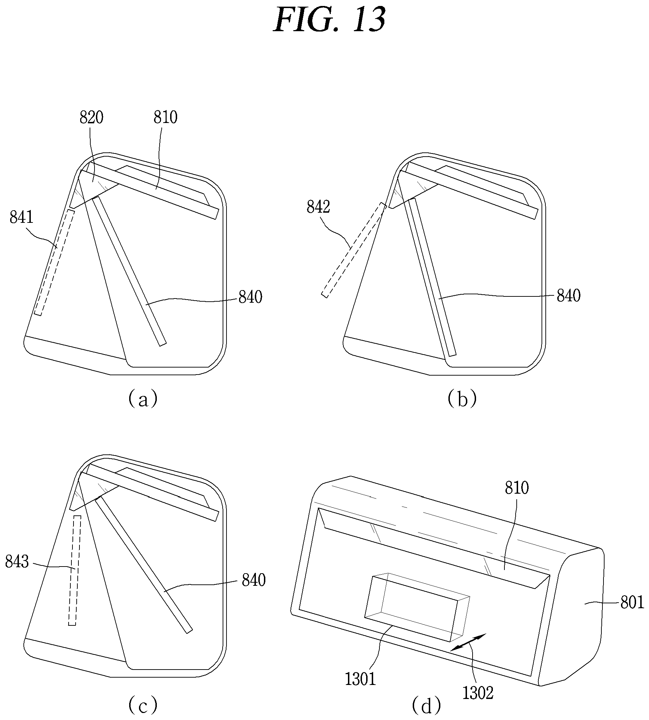

Subsequently, with reference to FIG. 13, a method of changing a position of an AR image displayed in the floating display region in the vehicular display device 800 according to the present disclosure is described in detail below.

A real image may be displayed on the surface of the prism in the first screen region formed through the first reflective module 820, and a 3D virtual (AR) image having a depth may be displayed in the second screen region formed through the second reflective module 840.

In an embodiment of the present disclosure, the 3D virtual (AR) image to be displayed in the second screen region may be displayed while moving along the X-axis, Y-axis, and Z-axis directions in the inner space in the housing 801. To this end, the 3D hologram plate of the second reflective module 840 is configured to be rotatable to adjust an inclination angle between the 3D hologram plate and the display 810.

Specifically, as illustrated in FIG. 13, the first reflective module 820 is fixed to one side of the display 810, and the second reflective module 840 is arranged in a rotatable structure within the inner space in the housing 801. One side of the second reflective module 840 is fixed to be adjacent to the first reflective module 820. The second reflective module 840 is formed in such a manner that the separation distance from the display 810 progressively increases toward the other side thereof. In addition, the second reflective module 840 is configured to allow the inclination angle between the second reflective module 840 and the display 810 to be adjustable by the operation of the rotation adjustment unit 860.

The processor 850 of the vehicular display device 800 may transmit a signal for adjusting the rotation of the second reflective module 840 to the rotation adjustment unit 860 in such a manner as to adjust the inclination angle between the second reflective module 840 and the display 810.

The rotation control unit 860 may include a coupling unit coupled to one side of the 3D plate of the second reflective module 840, a drive unit providing a driving force for rotating the 3D plate, and a support unit supporting the 3D plate while the 3D plate is rotated.

When the rotation control unit 860 operates in response to a driving signal transmitted from the processor 850, the 3D plate of the second reflective module 840 may rotate by a predetermined angle in a clockwise or counterclockwise direction based on information included in the driving signal.
(a) of FIG. 13 is an exemplary view illustrating the default basic position of the second reflective module 840 in the inner space in the housing 801. In a case where the 3D plate of the second reflective module 840 is arranged at the predetermined default position, the second screen region 841, where the 3D AR content is displayed, may be displayed, for example, at an opening of the inner space in the housing 801.
   In an embodiment, the processor 850 can adjust the rotation of the second reflective module 840 through the rotation control unit 860, thereby adjusting the inclination angle between the display 810 and the 3D plate. By doing so, the second screen region 841 in which the 3D AR content is displayed may be controlled in such a manner that a position thereof moves backward or forward with respect to the inner space in the housing 801.
(b) of FIG. 13 is a view illustrating an example in which the 3D plate of the second reflective module 840 rotates clockwise by a predetermined angle from the default position thereof, thereby further increasing the inclination angle between the display 810 and the 3D plate.
   In this manner, when the magnitude of the inclination angle between the display 810 and the 3D plate of the second reflective module 840 increases, the position of the second screen region 841 formed through the second reflective module 840, that is, the position of the floating display region, protrudes forward. Accordingly, at least one portion of the 3D AR image to be displayed in the second screen region 841 may be displayed outward from the inner space in the housing 801.
(c) of FIG. 13 is a view illustrating an example in which the 3D plate of the second reflective module 840 rotates counterclockwise by a predetermined angle from the default position thereof, thereby further decreasing the inclination angle between the display 810 and the 3D plate.
   In this manner, when the magnitude of the inclination angle between the display 810 and the 3D plate of the second reflective module 840 decreases, the position of the second screen region 841 formed through the second reflective module 840, that is, the position of the floating display region, is pushed backward, thereby displaying the second screen region 841. Accordingly, the 3D AR image to be displayed in the 2-second screen region 841 may be displayed further inside the inner space in the housing 801.
(d) of FIG. 13 is a view illustrating a state where, when the 3D plate of the second reflective module 840 rotates, a 3D AR image 1301 displayed in the second screen region, that is, in the floating display region 841, moves in a backward-forward direction 1302 in the inner space in the housing 801. At this point, a graphic displayed in the first screen region formed through the first reflective module 820, that is, in the prism display region, remains displayed on the same plane.

In this manner, the 3D AR image may move under various conditions when the position of the 3D plate of the second reflective module 840 changes.

In an embodiment, the processor 850 of the vehicular display device 800 may adjust the rotation of the second reflective module 840 in such a manner as to change the position of the second screen region. This adjustment is based on field-of-view information (i.e., an eye box or eye level) of an occupant detected by an IMS or DMS sensor of the vehicle 100, the field-of-view information being received from the vehicle 100. To this end, the processor 850 may calculate refraction, curvature, and optical path corresponding to the field-of-view information of the occupant detected through the IMS or DMS sensor. By doing so, when operating the display 810, the processor 850 may adjust the position of the 3D plate of the second reflective module 840.

In addition, in an embodiment, when operating the display 810, the processor 850 of the vehicular display device 800 may activate the first and second screen regions formed through the first and second reflective modules 820 and 840, respectively. Subsequently, the processor 850 may display a first graphic image, which is a real image, in the first screen region 821, that is, in the prism display region. Based on the movement of a second graphic image, which is an aerial (virtual) image, displayed in the second screen region 841, that is, in the floating display region, the processor 850 may adjust the rotation of the second reflective module 840 in such a manner as to adaptively change the position of the floating display region.

For example, in a case where the 3D AR image displayed in the floating display region is of a 3D content type configured to move backward or forward, the 3D plate of the second reflective module 840 may rotate in a manner that corresponds to such a movement pattern. Accordingly, the 3D virtual (AR) image, as illustrated in (d) of FIG. 13, may operate in such a manner as to move relative to the inner space formed by the recess of the housing 801. To this end, the 3D plate of the second reflective module 840 may operate in such a manner as to rotate according to a pattern preset on a per-content basis.

In addition, for example, in the case of content that is effective when the 3D (AR) virtual image is displayed in such a manner as to protrude toward the driver, the position may be changed in the direction of increasing the inclination angle between the 3D plate of the second reflective module 840 and the display 810. Conversely, in the case of content that is effective when the 3D (AR) virtual image is displayed in such a manner as to be introduced into the housing 801, the position may be changed in the direction of decreasing the inclination angle between the 3D plate of the second reflective module 840 and the display 810. For example, the 3D virtual (AR) image of the second reflective module 840 may rotate clockwise or counterclockwise to create an effect where the 3D virtual (AR) image appears to be zoomed in or out. Alternatively, the 3D plate of the second reflective module 840 may be maintained in a fixed state, and the housing, including the package, may rotate in a specific direction, thereby achieving the same or similar effect.

The above-mentioned package may be configured to have a structure that is rotatable together with the dashboard of the vehicle 100. In this case, the inner space formed by the recess of the housing 801 may be exposed or closed in response to the rotation of the package. As another example, a front cover for closing the inner space formed by the recess of the housing 801 may be further included.

Various embodiments in which, according to an embodiment of the present disclosure, the prism region and the floating region have different depth values or information is displayed by changing the depth values.

With reference back to FIG. 5, as described above, the prism region is the first screen region in which information of a graphic displayed in the display 810 is displayed above the prism. In addition, the floating region is the second screen region in which the graphic displayed on the display 810 is reflected by the 3D plate and in which an aerial image, that is, the floating AR image, is displayed in the inner space of the housing 801.

Information in the prism region and information in the floating region are displayed in such a manner that phases thereof are shifted by 180 degrees. Specifically, a graphic output on the display 810, which is positioned in the upper portion of the inner space in the housing 801, that is, a source image, is displayed as images whose phases are shifted by 180 degrees in the prism region and the floating region.

In addition, the images displayed in the prism region and the prism region, respectively, are displayed to have different depth values. The image displayed in the prism region is a real image, and the image displayed in the floating region is an aerial image reflected by the 3D plate. Images displayed in a plurality of regions have different depth values.

The prism region may be divided into a 'driver essential zone' in which essential driving information of the vehicle is displayed, and a 'control zone' in which operations, such as touch input, are possible. At this point, for example, information such as vehicle speed and RPM may be displayed on the driver's essential zone of the prism region. In addition, for example, HAVC control, a menu icon, and the like may be displayed on the control zone of the prism region.

The floating region may be divided into a sharing zone, included in the fields of vision of both a driver and a passenger, the driver's private zone, and the passenger's private zone.

In addition, as illustrated in FIG. 13, as the 3D plate of the second reflective module 840 rotates or moves, information displayed in the floating region may move along the X-axis, Y-axis, and Z-axis directions, or the depth value of the 3D content may be changed.

In embodiments of the present disclosure, information displayed in the prism region may be displayed in a manner that expands into the floating region. In addition, similarly, information displayed in the floating region may be displayed in a manner that is reduced into the prism region.

In an embodiment of the present disclosure, the vehicular display device 800 may use, as a source image, the graphic light emitted from the display 810, which is obliquely arranged on one side of the inner space in the housing, for example, in the upper portion. By doing so, the vehicular display device 800 may display a real image and an aerial image in the first screen region (that is, the prism region) 821 and the second screen region (i.e., the floating region), respectively.

To this end, the graphic light emitted from the first region of the display 810 is refracted through the first reflective module 820, thereby forming the first screen region 821. In addition, the graphic light emitted from the second region of the display 810 is reflected by the second reflective module 840, or is reflected by the second reflective module 840 after being refracted through the first reflection module, thereby forming the second screen region 840.

When operating the display 810, the processor 850 arranged in the rear portion of the inner space in the housing 801 may control the display 810 on the basis of vehicle information received from the vehicle 100 in such a manner that pieces of information having different depth values are displayed in the first and second screen regions 821 and 841, formed through the first and second reflective module 820 and 840, respectively.

In an embodiment, pieces of information associated with each other may be seamlessly displayed on the first and second screen regions 821 and 841, respectively.

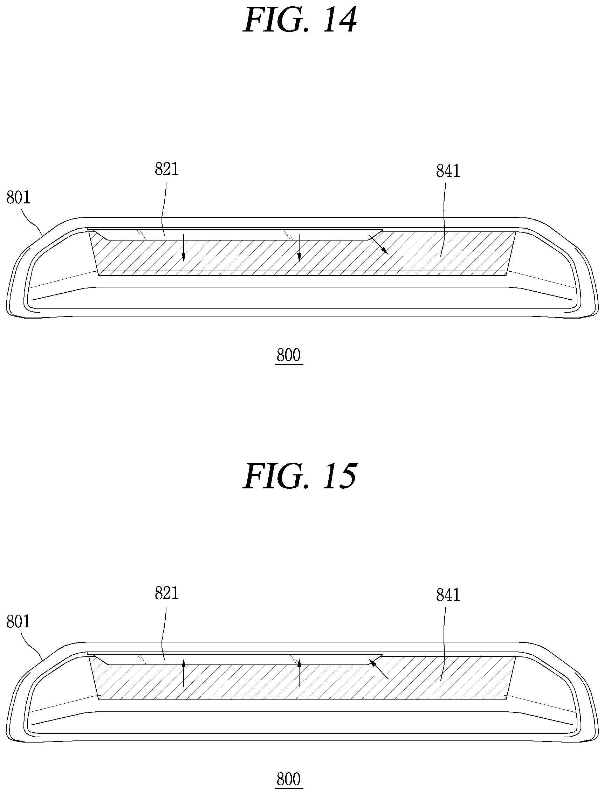

In this regard, FIGS. 14 and 15 are views that are referenced to describe a state where the information in the prism region 821 is displayed in a manner that expands into the floating region 841 or where the information in the floating region 841 is displayed in a manner that is reduced into the prism region.

The processor 850 may determine pieces of information to be displayed in the first and second screen regions 821 and 841, respectively, on the basis of the received vehicle information. In addition, the processor 850 may determine whether the pieces of information to be displayed in the first and second screen regions 821 and 841, respectively, are associated with each other.

At this point, the association of pieces of information to be displayed includes displaying content, selected from the first screen region 821, in the second screen region 841.

In addition, the association of pieces of information to be displayed includes displaying information in the first screen region 821 and the second region 841 only as different types.

In addition, the association of pieces of information to be displayed includes displaying information, originally intended for display in the first screen region 821, in a manner that expands into the second screen region 841 when the information satisfies a preset condition.

In an embodiment, the processor 850 may determine whether pieces of information to be displayed in the first and second screen regions, that is, in the prism region 821 and the floating region 841, respectively, are associated with each other. Based on the determination, the processor 850 may control the first and second reflective modules 820 and 840 in such a manner that at least one of the depth values of a real image to be displayed in the prism region 821 and an aerial image to be displayed in the floating region 841 is changed.

With reference to FIG. 14, when the vehicular display device 800 is in operation, information associated with the information to be displayed in the prism region 821, formed in an upper portion of the housing 801, may be displayed in such a manner as to seamlessly expand from the prism region 821 to the floating region 841.

At this point, the information to be displayed in the floating region 841 formed below the prism region 821 may appear to be spread downward from the prism region 821. Accordingly, the user can intuitively recognize that pieces of information displayed in the prism region 821 and the floating region 841, respectively, are associated with each other.

In addition, when associated information is seamlessly displayed in the floating region 841, a highlighting effect (e.g., a change in the size or color of an image, or a blinking effect) may be applied to the formation displayed in the corresponding prism region 821. Accordingly, the user can intuitively recognize in a visual way whether the information displayed in the floating region 841 is associated with any information displayed in the prism region 821.

Subsequently, with reference to FIG. 15, in a case where the information that is associated with the information displayed in the prism region 821 and is displayed in the floating region 841 is changed or disappears, the operation of the display 810 and the operations of the first and second reflective modules 820 and 840 may be controlled in such a manner that the pre-change or disappearing information moves toward the prism region 821.

At this point, a preset visual effect may be applied to association information displayed in the prism region 821. For example, in a case where, while one image is displayed across the prism region 821 and the floating region 841 in a seamlessly continuous manner, a portion thereof displayed in the floating region 841 is changed or disappears, information displayed in a corresponding portion of the prism region 821 may be accordingly reduced in size, changed, or removed. Accordingly, the user can intuitively recognize which information is disassociated in the prism region 821.

In FIGS. 14 and 15, depth values may be adjusted in such a manner that images are positioned on the same plane in respective portions of the prism region 821 and the floating region 841, where pieces of information associated with each other are displayed. Conversely, in respective portions of the prism region 821 and the floating region 841 where pieces of information not associated with each other are displayed, images may have different depth values and/or may be positioned on different planes.

Accordingly, the user can intuitively recognize information displayed continuously across the prism region 821 and the floating region 841.

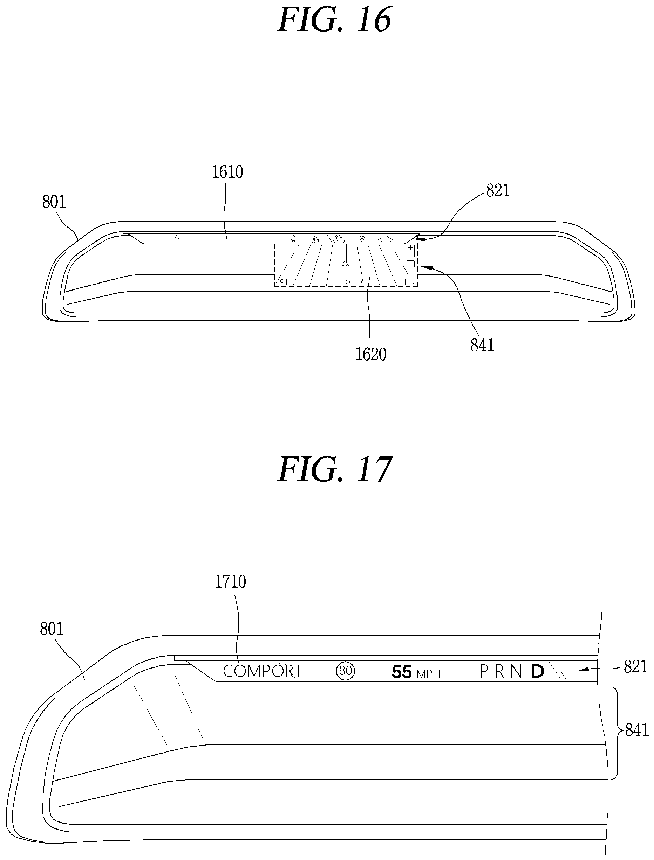

FIG. 16 is a view illustrating an example in which vehicle navigation information is displayed continuously across the prism region 821 and the floating region 841.

A real image, resulting from a source image being refracted through the prism, may be displayed in the prism region 821. An aerial image, formed as a result of the source image being directly reflected by the 3D plate, or being reflected by the 3D plate after passing through the prism (after being refracted by the prism), that is, a virtual 3D content, is displayed in the floating region 841.

Based on the association of pieces of information to be displayed in the prism region 821 and the floating region 841, respectively, the processor 850 may adjust the depth values through the first and second reflective module 820 and 840 in such a manner that images to be displayed in the prism region 821 and the floating region 841, respectively, are positioned in the same plane.

In an embodiment, the processor 850 may determine that the pieces of information to be displayed in the prism region 821 and the floating region 841, respectively, are associated with each other. Based on the determination, the image to be displayed in the floating region 841 may be displayed in the prism region 821 while moving downward from above in a seamlessly continuous manner.

With reference to FIG. 16, navigation screen may be seamlessly displayed in such a manner as to be continuous across the prism region and the floating region of the display 810 corresponding to the space between the driver's seat and the front passenger seat of the vehicle 100. At this point, menu content 1610 related to navigation screen control may be displayed in the prism region 821 above. Along with this, a navigation execution screen 1620, seamlessly connected to the menu content 1610, may be displayed as a virtual (AR) image in the floating region 841 in such a manner as to have a depth value on the same plane.

Although not illustrated in detail, menu content for executing navigation may be displayed in the prism region 821 above, and, in response to a selection in the prism region 821, a navigation execution screen may be seamlessly displayed in the floating region 841. At this point, the navigation execution screen may appear while being spread downward, originating from the point where the selection in the prism region 821 is authorized. Accordingly, the user can intuitively recognize that the prism region 821 and the floating region 841 are used in conjunction with each other.

In another embodiment, the processor 850 determines that pieces of information to be displayed in the prism region 821 and the floating region 841 are associated with each other. Based on the determination, content related to the vehicle information is displayed in the prism region 821, and a result of executing the content may be displayed in the floating region 841 that matches the content.

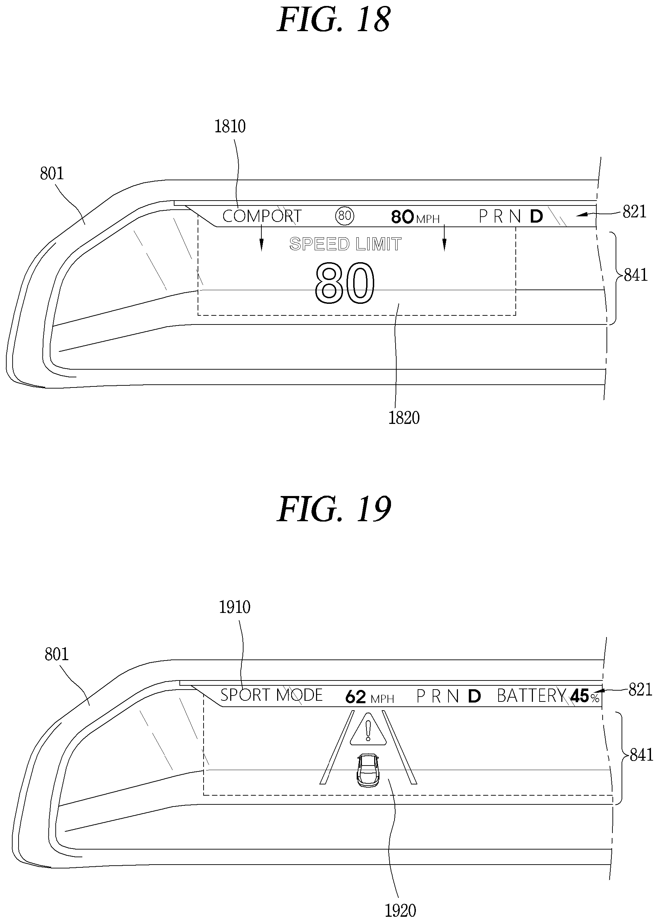

FIGS. 17 and 18 are views illustrating an example in which, according to a warning level corresponding to a vehicle speed, warning information is displayed in a manner that expands into the floating region.

In addition, FIG. 19 is a view illustrating an example in which, based on a distance between vehicles, the warning information is displayed in a manner that expands into the floating region.

The graphic light emitted from the display 810, that is, a source image, may be independently displayed in each of the prism region 821 and the floating region 841 through the first and second reflective module 820 and 840, respectively. That is, while one source video is provided, a plurality of screen regions are used independently.

The processor 850 may determine which information is to be displayed in which screen region. In addition, the processor 850 may preset a reference for determining information to be displayed in the prism region 821 and the floating region 841. When operating the display 810, the processor 850 may display the information in each screen region according to the preset reference.

In addition, in an embodiment, the processor 850 may receive vehicle state information from the vehicle 100. Based on an importance level of the vehicle information included in the received vehicle state information, the processor 850 may control the first and second reflective modules 820 and 840 in such a manner that the information is selectively displayed at different depth values in each of the first and second screen regions 821 and 841.

For example, among the received pieces of vehicle state information, important information, which should not be affected by ambient brightness, may be displayed in the prism region 821, where a darkroom effect is unnecessary. In addition, for example, a position of the graphic light emitted from the display 810 may be adjusted in such a manner that, among the received pieces of vehicle state information, important information related to safety is displayed in the prism region 821. In addition, for example, driving information of other vehicles or content defined/set by the user may be displayed in the floating region 841, which is displayed as a virtual (AR) image.

With reference to FIG. 17, for example, vehicle state information 1710 that is always displayed while the vehicle is being driven may be displayed in the prism region 821 formed narrowly in the upper portion of the housing 801. For example, a vehicle speed (e.g., 55 m/h), a residual fuel or battery level, a vehicle state alarm, and the like may be included as information to be displayed in the prism region 821.

More expanded secondary information may be displayed as a virtual (AR) image in the floating region 841 formed widely under the prim region 821 in the housing 801, with information being displayed as primary information in the prism region 821.

With reference to FIG. 18, for example, when a speed (e.g., 80 m/h) 1810 displayed in the prism region 821 exceeds the speed limit, a numeric image 1820 indicating the current vehicle speed may be displayed in a manner that expands into the floating region 841. At this point, the image displayed in the floating region 841 may vary according to the importance or warning level.

For example, the more the current vehicle speed exceeds the speed limit, the larger the size of an image displayed in the floating region 841 and the higher the alarm level. Conversely, when the current vehicle speed decreases in the degree of exceeding the speed limit, the display 810 and the second reflective module 840 may be controlled in such a manner that the image displayed in the floating region 841 is reduced in size or is no longer displayed.

Subsequently, with reference to FIG. 19, as an example of a result of executing content 1910 displayed in the prism region 821, a driving warning image 1920 due to a reduction in the inter-vehicle distance is displayed in 3D in the corresponding floating region 841.

Specifically, the processor 850 of the vehicular display device 800 may control the display 810 and the first reflective module 820 in such a manner as to display driving guidance information, as content related to the vehicle information, in the prism region 821.

In addition, the processor 850 may determine, based on the vehicle state information, that the importance level of the driving guidance information has changed. Based on the determination, the processor 850 may display the extended driving guidance information, as a result of executing the content in the prism region 821, in the floating region 841. To this end, the processor 850 may adjust the display 810 and the 3D plate of the second reflective module 840 in such a manner that the expanded driving guidance information is displayed as a 3D image in a position corresponding to the content in the prism region 821.

In order to ensure that images to be displayed in the prism region 821 and the floating region 841 are displayed on the same plane, the processor 850 may drive the rotation control unit 860 in such a manner that, as illustrated in FIG. 13, the 3D plate of the second reflective module 840 rotates.

For example, in a case where, as illustrated in FIG. 19, a separation distance between the vehicle and a preceding vehicle (or an obstacle) is reduced to within a reference value and thus a warning alarm is determined to be necessary, the warning message 1920 may be displayed in the floating region 841 on the same plane matched to the content 1910 in the prism region 821, the content 1910 being related to the inter-vehicle distance (the distance to the obstacle).

Although not illustrated in detail, as a warning or attention level increases, the second reflective module 840 may be controlled in such a manner that the 3D plate of the second reflective module 840 is rotated backward or forward, thereby moving the warning image 1920 backward or forward relative to the inner space in the housing 801.

In addition, in an embodiment, the processor 850 may determine that pieces of information displayed in the prism region 821 and the floating region 841, respectively, have been disassociated. In addition, based on the determination of the disassociation, the processor 850 may control the operations of the first and second reflective module 820 and 840 in such a manner that the 3D image in the floating region 841 disappears during movement to a boundary between the prism region 821 and the floating region 841 while the information remains displayed in the prism region 821.

In this manner, the vehicular display device according to the embodiment of the present disclosure may display pieces of information associated with each other, which are derived from one source image, in the prism region and the floating region, as if the pieces of information appear as one seamlessly connected screen. In addition, the result of executing the content displayed in the prism region may also be displayed in the floating region. In addition, depending on whether to increase an attention or alarm level, information displayed only in the prism region may be displayed in a manner that expands into the floating region, or an image may be no longer displayed in the floating region. Accordingly, different screen regions may be used independently, and the user can intuitively recognize whether pieces of information are associated with each other.

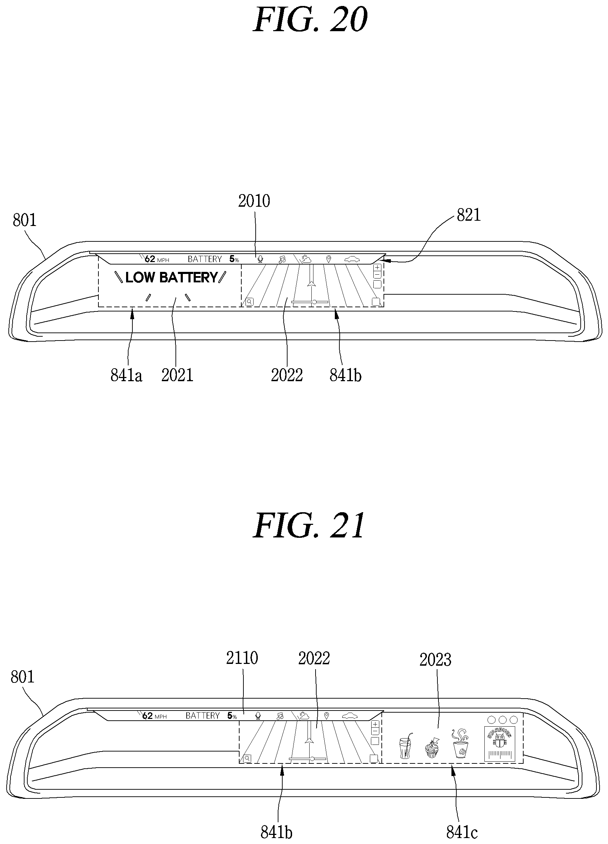

FIGS. 20 and 21 are exemplary views that are referenced to describe the prism region and the floating region that are allocated to an occupant in the driver's seat and an occupant in the front passenger seat, respectively.

In an embodiment of the present disclosure, the vehicular display device 800 may be configured in such a manner that the prism region and the floating region that correspond to the driver's seat and the floating region that corresponds to the front passenger seat are distinguished from each other.

For example, FIG. 20 illustrates the prism region 821, a floating region 841a (hereinafter referred to as a 'first floating region 841a') for the driver, and a common floating region 841b (hereinafter referred to as a 'second floating region 841b').

In addition, for example, FIG. 21 illustrates the prism region 821, a floating region 841c (hereinafter referred to as a 'third floating region 841c') for an occupant in the front passenger seat, and the common floating region 841b (hereinafter referred to as the 'second floating region 841b').

Vehicle information 2010, such as information about the vehicle state or important information related to driving, may be commonly displayed in the prism region 821 in the upper portion of the housing 801 illustrated in FIGS. 20 and 21. The prism region 821, as illustrated, may be formed only at a position corresponding to the driver's seat, as illustrated. Although not illustrated, the prism region may also be formed to extend longitudinally to the front passenger seat. In the latter case, the vehicle information 2010 may be displayed only at the position corresponding to the driver's seat.

In FIGS. 20 and 21, the first, second, and third floating regions 841a, 841b, and 841c may be independently formed, and different content items not associated with each other may be displayed in the first, second, and third floating regions 841a, 841b, and 841c. To this end, when an occupant in the front passenger seat is not detected, the processor 850, as illustrated in FIG. 20, may activate only the first and second floating regions 841a and 841b. In addition, when an occupant in the front passenger seat is detected, the processor 850, as illustrated in FIG. 21, may activate only the second and third floating regions 841b and 841c or may activate all of the first, second, and third floating regions 841a, 841b, and 841c.

A result of executing content related to the vehicle may be displayed in the first floating region 841a. For example, as illustrated in FIG. 20, notification information 2021 indicating battery shortage or charging may be displayed as a 3D image.

A result of executing common content related to driving may be displayed in the second floating region 841b. For example, as illustrated in FIGS. 20 and 21, a navigation screen 2022 for guiding the vehicle to a destination may be displayed as a moving 3D image.

A result of executing entertainment for an occupant in the front passenger seat may be displayed in the third floating region 841c. For example, as illustrated in FIG. 21, an advertisement screen 2023 provided by a POI in the vicinity of a current location of the vehicle may be displayed as a 3D moving image.

Pieces of information to be displayed in the prism region 821 and the floating region 841, respectively, may be independently displayed instead of being associated with each other.

Based on the determination that the pieces of information to be displayed in the prism region 821 and the floating region 841, respectively, are not associated with each other, the processor 850 may control the display 810 and the 3D plate of the second reflective module 840 in such a manner that an image to be displayed in the floating region 841 is vertically spread, originating from the center of the floating region.

In addition, in another embodiment, based on the determination that the pieces of information to be displayed in the prism region 821 and the floating region 841, respectively, are not associated with each other, the processor 850 may control the display 810 and the 3D plate of the second reflective module 840 in such a manner that an image to be displayed in the floating region 841 is displayed while moving upward from below the floating region.

In this manner, an image displayed in the floating region 841 provides a visual effect starting at a distance away from the prism region 821. Thus, the user can intuitively recognize that information in the prism region 821 and information in the floating region 841 are not associated with each other.

In an embodiment, the prism region 821 of the vehicular display device 800 may be formed in such a manner that the prism is layered with a touch sensor or proximity sensor to enable a touch input.

In this case, at least one portion of the prism region 821 and at least one portion of the floating region 841 may be used in conjunction with each other on the basis of a touch input to content displayed in the prism region 821.

Specifically, based on the touch input to the content displayed in the prism region 821 formed to enable a touch input, the processor 850 may control the display 810 and the first and second reflective modules 820 and 840 in such a manner as to display an execution result matched to the touch input in the corresponding floating region 841. Now, pieces of formation displayed in the prism region 821 and the floating region 841, respectively, have been associated with each other.

Subsequently, based on successive touch inputs applied to content displayed in the prism region 821, the processor 841 may control the display 810 and the first and second reflective modules 820 and 840 in such a manner that the execution result displayed in the corresponding floating region 841 is changed or disappears. In the latter case, pieces of information displayed in the prism region 821 and the floating region 841, respectively, have been disassociated with each other.

For driving safety, the formation of a portion of the screen region by the vehicular display device 800 may be limited. To this end, the formation of the floating region and/or the information displayed in the floating region may be determined in a manner that varies with the vehicle driving state.

While the vehicle is driven in a manual driving mode, the processor 850 of the vehicular display device 800 may display the vehicle information in the prism region 821. Furthermore, the processor 850 may control the operation of the display 810 and the operations of the first and second reflective modules 820 and 840 in such a manner that the floating region 841 remains deactivated or only the notification information is locally displayed in the floating region 841, depending on driving situations.

Conversely, while the vehicle is in a stopped state or is driving in the autonomous driving mode, the processor 850 of the vehicular display device 800 may display a minimum amount of vehicle information in the prism region 821 and may display an execution screen for an entertainment function in the floating region 841.

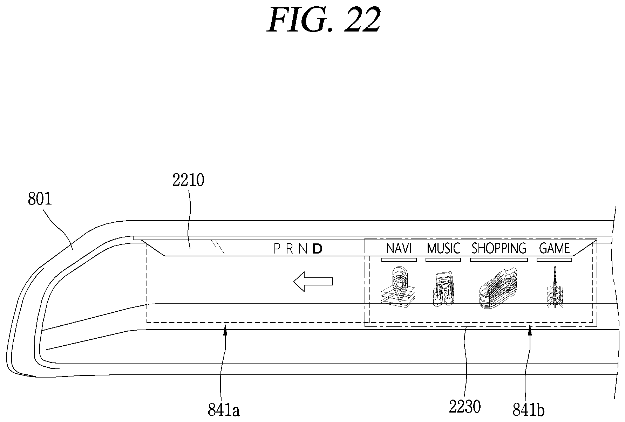

FIG. 22 is a view illustrating an example in which a result of executing the entertainment function is displayed on the basis of the vehicle driving state in a manner that expands into the floating region.

In an embodiment, while pieces of information or images having different depth values are displayed in the first screen and second screen regions 821 and 841, that is, the prism region and the floating region, respectively, the processor 850 of the vehicular display device 800 may control the second reflective module 840 based on the driving situation included in the received vehicle information in such a manner as to limit display in the floating region.

For example, when it is determined, based on the received vehicle information, that the vehicle is driven, but not in an autonomous driving mode, the vehicular display device 800 may operate the second reflective module 840 in such a manner that the floating region is formed in a limited-operation mode for limiting the driver's field of view.

In addition, in a state where the vehicle is stopped or is driven in the autonomous driving mode on the basis of the vehicle information received by the vehicular display device 800, when operating the display 810, the processor 850 may adjust depth values of a plurality of screen regions in such a manner that images to be displayed in the first and second screen regions 821 and 841 are positioned on the same plane in a seamlessly continuous manner.

To this end, the processor 850 may control a refraction angle or a reflection path of the first reflective module 820, and/or may adjust the position of the 3D plate of the second reflective module 840, and/or a path of light incident on the user's eyes.

With reference to FIG. 22, while menu content 2210 including the vehicle information is displayed in the prism region 821 in a stopped state of the vehicle, information may not be displayed in the first floating region 841a, and an entertainment screen 2230, as a result of executing content selected from menu content 2210 in the prism region 821, may be displayed in the second floating region 841b.

In addition, although not illustrated, in a state where the vehicle is in a stopped state, when an additional input is applied to the menu content 2210 in the prism region 821, the entertainment screen 2230 in the second floating region 841a may be displayed in a manner that expands into the first floating region 841a. That is, while the vehicle is not driven, an entertainment screen or image may also be displayed in the floating region for the driver.

In this case, the entertainment screen 2230 displayed in the first and second floating regions 841a and 841b, as illustrated in FIG. 13, may move along the X-axis, Y-axis, and Z-axis directions within the housing 801. In this case, the menu content 2210 in the prism region 821 matched to at least one of the first and second floating regions 841a and 841b may also vary correspondingly. For example, a content menu related to the entertainment function may be displayed at a position corresponding to the driver's seat in the prism region 821.

As described above, the vehicular display device according to the embodiment of the present disclosure, and the method of operating the vehicular display device, a plurality of different display modes may be executed selectively or simultaneously using a single display module. For example, a real image or an aerial image may be displayed selectively or simultaneously using only a single display. In addition, by adjusting and displaying the sense of depth according to whether a real image and an aerial image are associated with each other, the user can intuitively recognize whether pieces of information displayed in different types of screens, respectively, are associated with each other. Specifically, when pieces of information associated with each other, which are derived from one source image, are displayed in the prism region and the floating region, respectively, they may be displayed as if they appear as one seamlessly connected screen. In addition, a result of executing content displayed in the prism region may also be displayed in the floating region. In addition, depending on whether to increase the attention or alarm level, information displayed only in the prism region may be displayed in a manner that expands into the floating region, or an image may be no longer displayed in the floating region. Accordingly, a more diverse user environment and user experience are provided by using different screen regions independently or in an associated manner.

The present disclosure may be implemented in the form of computer-readable code recorded on a program-recorded medium. Computer-readable media include all types of recording devices capable of storing data that are readable by a computer system. Examples of computer-readable media include hard disk drives (HDDs), solid-state disks (SSDs), silicon disk drives (SDDs), ROM, RAM, CD-ROM, magnetic tapes, floppy disks, optical data storage devices, and other similar media. In addition, these media may further include transmission media, such as waves (e.g., waves transmitted over the Internet). In addition, the computer may also include a processor of the vehicular display device 800. Therefore, the detailed description should not be construed as limiting in any respect, but should be regarded as illustrative in nature. The scope of the present disclosure should be determined by the proper interpretation of the following claims. All equivalent modifications to the embodiments of the present disclosure fall within the scope of the present disclosure.

## Claims

1. A vehicular display device comprising:
a housing recessed to form an inner space inside;
a display arranged on one side of the inner space in the housing;
a communication module that receives vehicle information from a vehicle;
a first reflective module coupled to one side of the display in the inner space and arranged in such a manner that graphic light emitted from a first region of the display forms a first screen region after refraction;
a second reflective module coupled to one side of the first reflective module in the inner space and arranged in such a manner that graphic light emitted from a second region of the display forms a second screen region after reflection; and
a processor electrically coupled to the first and second reflective modules and controlling respective operations of the first and second reflective modules,
wherein, when operating the display, the processor controls the first and second reflective modules on the basis of the received vehicle information in such a manner that pieces of information having different depth values are displayed in the first and second screen regions, respectively.

2. The vehicular display device of claim 1, wherein the processor determines whether pieces of information to be displayed in the first and second screen regions, respectively, are associated with each other, and, based on the determination, controls the first and second screen regions in such a manner that the depth values are changed.

3. The vehicular display device of claim 2, wherein the first screen region is a prism region, and the second screen region is a floating region in which a virtual (AR) image is displayed below the prism region, and
wherein, based on the association of the pieces of information to be displayed in the prism region and the floating region, respectively, the processor adjusts the depth values through the first and second reflective modules in such a manner that images to be displayed in the prism region and the floating region, respectively, are positioned on the same plane.

4. The vehicular display device of claim 3, wherein, based on the association of the pieces of information to be displayed in the prism region and the floating region, respectively, an image to be displayed in the floating region is displayed in the prism region while moving downward from above in a seamlessly continuous manner.

5. The vehicular display device of claim 3, wherein the processor controls the display and the first and second reflective modules based on the association of the pieces of information to be displayed in the prism region and the floating region, respectively, in such a manner that content related to the vehicle information is displayed on the prism region and that a result of executing the content is displayed in the floating region.

6. The vehicular display device of claim 5, wherein driving guidance information is displayed as content related to the vehicle information in the prism region, and, based on a change in an importance level of the driving guidance information, the extended driving guidance information, as a result of executing the content, is displayed in the floating region.

7. The vehicular display device of claim 5, wherein the prism region is formed to receive a touch input, and
wherein, based on a touch input to content displayed in the prism region, the processor controls the display and the first and second reflective modules in such a manner that an execution result matched to the touch input is displayed in the floating region.

8. The vehicular display device of claim 3, wherein, in a case where the pieces of information displayed in the prism region and the floating region, respectively, are disassociated with each other, the image in the prism region remains displayed, and the image in the floating region disappears during movement to a boundary between the prism region and the floating region.

9. The vehicular display device of claim 3, wherein, based on disassociation of the pieces of information to be displayed in the prism region and the floating region, respectively, the image to be displayed in the floating region is vertically spread, originating from the center of the floating region.

10. The vehicular display device of claim 3, wherein, based on disassociation of the pieces of information to be displayed in the prism region and the floating region, respectively, the image to be displayed in the floating region is displayed while moving upward from below the floating region.

11. The vehicular display device of claim 1, wherein, in a state where the vehicle is stopped or is driven in an autonomous driving mode on the basis of the received vehicle information, when operating the display, the processor adjusts the depth values in such a manner that images to be displayed in the first and second screen regions, respectively, are positioned on the same plane in a seamlessly continuous manner.

12. The vehicular display device of claim 1, wherein, based on an importance level of the vehicle information, the processor controls the first and second reflective modules in such a manner that the pieces of information having different depth values are selectively displayed in the first and second screen regions, respectively.

13. The vehicular display device of claim 1, wherein, while the pieces of information having different depth values are displayed in the first and second screen regions, respectively, the processor controls an operation of the second reflective module based on a driving situation included in the vehicle information in such a manner as to limit display in the second screen region.
